(19) Europäisches Patentamt
European Patent Office
Office européen des brevets

(11) EP 2 003 520 A2

(12) **EUROPEAN PATENT APPLICATION**
published in accordance with Art. 153(4) EPC

(43) Date of publication:
**17.12.2008 Bulletin 2008/51**

(21) Application number: **07714291.7**

(22) Date of filing: **15.02.2007**

(51) Int Cl.:
***G03H 1/02*** (2006.01) ***G03F 7/004*** (2006.01)
***G03F 7/038*** (2006.01) ***G11B 7/0065*** (2006.01)
***G11B 7/24*** (2006.01)

(86) International application number:
**PCT/JP2007/052761**

(87) International publication number:
**WO 2007/105404 (20.09.2007 Gazette 2007/38)**

(84) Designated Contracting States:
**DE FR GB**

(30) Priority: **10.03.2006 JP 2006066675**

(71) Applicant: **FUJIFILM Corporation**
**Minato-ku**
**Tokyo 106-0031 (JP)**

(72) Inventor: **KAMO, Makoto**
**Shizuoka 4188666 (JP)**

(74) Representative: **Grünecker, Kinkeldey, Stockmair & Schwanhäusser Anwaltssozietät**
**Leopoldstrasse 4**
**80802 München (DE)**

(54) **PHOTOSENSITIVE COMPOSITION, OPTICAL RECORDING MEDIUM AND METHOD FOR MANUFACTURING SAME, OPTICAL RECORDING METHOD, AND OPTICAL RECORDING APPARATUS**

(57) The present invention provides a photosensitive composition containing (A) a photoreactive material, (B) an epoxy compound having an average epoxy equivalent of 230 g/eq. or less and having two or more epoxy groups in the molecule thereof, and (C) a thiol group-containing compound, which is used for forming a recording layer which records information using holography. In the photosensitive composition, preferably, (B) the epoxy compound reacts with (C) the thiol group-containing compound to form a polymerized product. The present invention also provides an optical recording medium having a recording layer formed of the photosensitive composition.

FIG. 3

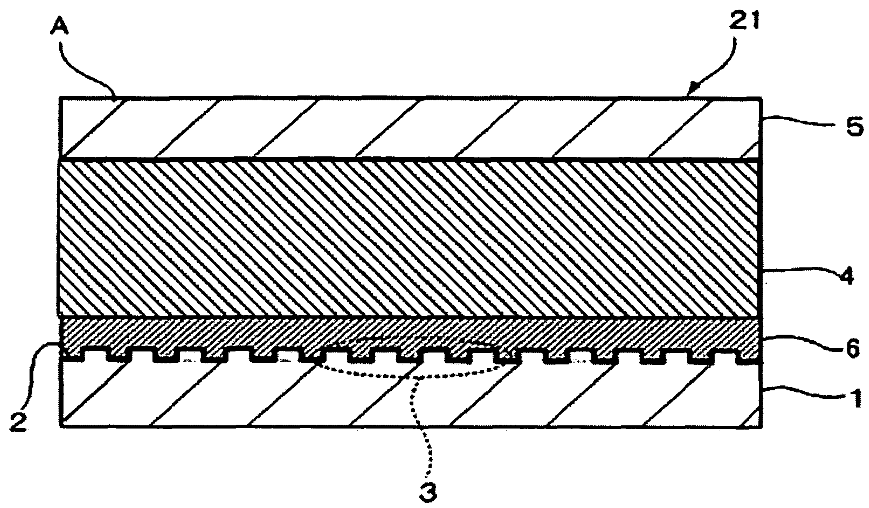


EP 2 003 520 A2

## Description

Technical Field

The present invention relates to a photosensitive composition used for forming a recording layer which records information using holography, and to an optical recording medium, a method for manufacturing the optical recording medium, an optical recording method and an optical recording apparatus.

Background Art

Optical recording media are one of the recording media which can write a large volume of information such as high-density image data. The optical recording media which have already been put into practice are, for example, rewritable optical recording media (e.g., magnetic optical discs and phase-change optical discs) and recordable optical recording media (e.g., CD-R). Nevertheless, still increased demand has arisen for optical recording media having much larger storage capacity. Conventional optical recording media record information two-dimensionally, which imposes limitation on increase in storage capacity. In view of this, recent interest has focused on hologram optical recording media which can record information three-dimensionally.

In general, the hologram optical recording media record information by superposing, inside a photosensitive recording layer, an information beam having a two-dimensional intensity distribution and a reference beam having an intensity almost equal to that of the information beam, and by forming an optical characteristic distribution inside the recording layer using the formed interference pattern. Meanwhile, written information is read (reproduced) by applying only a reference beam to the recording layer in the same arrangement as employed in recording to emit, from the recording layer, a reproduction beam having an intensity distribution corresponding to the optical characteristic distribution formed inside the recording layer.

The hologram optical recording medium is based on a three-dimensional optical characteristic distribution formed inside the recording layer. Thus, the hologram optical recording medium attains multiplex recording, a method in which a first region where information has been recorded by a first information beam can be partially overlapped with a second region where information has been recorded by a second information beam. In use of digital volume holography, the signal-to-noise ratio (S/N ratio) at one spot is extremely high and thus, even when the S/N ratio is rather reduced as a result of multiplex recording, the original information can be reproduced with fidelity. By virtue of these characteristics, the hologram optical recording medium allows multiplex recording at as many as several hundreds times, and exhibits remarkably increased storage capacity (see Patent Literature 1).

One optical recording medium is the type of an optical recording medium 20 shown in FIG.1, wherein a recording layer 4 is sandwiched between substrates 10 and 11. Another optical recording medium is the type of an optical recording medium 21 shown in FIG.2, which includes, in sequence, a first substrate 1, a first gap layer 8, a filter layer 6, a second gap layer 7, a recording layer 4 and a second substrate 5. The optical recording medium 21 is for use in a recording method in which an information beam and a reference beam are irradiated so that the optical axis of the information beam is coaxial with that of the reference beam. The number of times of multiplex recording in the recording layer of such an optical recording medium may be determined based on a dynamic range. The dynamic range is a measure of "how many holograms with a certain diffraction efficiency can be multiplexed". Specifically, the dynamic range is defined as a value determined by calculating the sum of the square roots of the diffraction efficiency of holograms multiplexed. Such a dynamic range may be increased by improvement in, for example, formation of a recording layer, a composition for forming a recording layer, or a recording method. In one improved method for recording layer formation, a plurality of recording layers are laminated (i.e., increase in thickness) so that the dynamic range increases. However, as the number of the layers laminated increases, unevenness in thickness occurs and production efficiency drops, which is problematic.

In an attempt to form a thick photosensitive layer and to rapidly manufacture a holographic recording medium without heating at high temperature, there is proposed an optical product containing a polymerized product formed between a photoreactive material and a material containing an NCO-ended prepolymer and a polyol (see Patent Literature 2). In this proposed optical product, since the isocyanate group is considerably easily hydrolyzed, the polymerized product is undesirably cured at high humidity. Thus, the product is very difficult to handle in a liquid state. In addition, some components are degraded during laser exposure for information recording, causing problematic coloring.

Under such circumstances, keen demand has arisen for a photosensitive composition which is stable at high humidity, which allows easy handling over time in a liquid state, which does not require high temperature conditions for curing, which contributes to rapid manufacture, and which can be applied to various molding methods; an optical recording medium having a recording layer formed of the photosensitive composition; a method for manufacturing the optical recording medium; an optical recording method; and an optical recording apparatus.

Patent Literature 1: Japanese Patent Application Laid-Open (JP-A) No. 2002-123949

Patent Literature 2: JP-A No. 2004-537620

Disclosure of Invention

An object of the present invention is to provide a photosensitive composition which is stable at high humidity, which allows easy handling over time in a liquid state, which does not require high temperature conditions for curing, which contributes to rapid manufacture, and which can be applied to various molding methods; an optical recording medium having a sufficient sensitivity and multiplex recording performance; a method for manufacturing the optical recording medium; an optical recording method; and an optical recording apparatus.

The present invention provides the following in order to solve the above-described problems.

<1> A photosensitive composition containing (A) a photoreactive material, (B) an epoxy compound having an average epoxy equivalent of 230 g/eq. or less and having two or more epoxy groups in the molecule thereof, and (C) a thiol group-containing compound, wherein the photosensitive composition is used for forming a recording layer which records information using holography.

<2> The photosensitive composition according to <1> above, wherein (B) the epoxy compound reacts with (C) the thiol group-containing compound to form a polymerized product.

<3> The photosensitive composition according to any one of <1> and <2> above, wherein a mixture of (B) the epoxy compound and (C) the thiol group-containing compound turns into a gel within 30 min after heating to 30°C.

<4> The photosensitive composition according to any one of <1> to <3> above, wherein a mixture of (B) the epoxy compound and (C) the thiol group-containing compound spontaneously exhibits an exothermic peak within 30 min after mixing.

<5> The photosensitive composition according to any one of <1> to <4> above, wherein (B) the epoxy compound contains an ethylene oxide moiety.

<6> The photosensitive composition according to any one of <1> to <5> above, wherein (C) the thiol group-containing compound is a mercaptan compound.

<7> The photosensitive composition according to any one of <1> to <6> above, wherein (A) the photoreactive material contains a polymerizable compound and a polymerization initiator.

<8> The photosensitive composition according to <7> above, wherein the polymerizable compound is at least one compound selected from radical polymerizable compounds.

<9> The photosensitive composition according to any one of <1> to <8> above, further containing a curing promoter which is at least one of a tertialy alkylamine, a tertialy aromatic amine and a tertialy alicyclic amine.

<10> The photosensitive composition according to any one of <1> to <9> above, wherein the photosensitive composition has a water content as measured by the Karl Fischer's method of 0.01% by mass to 2.5% by mass.

<11> An optical recording medium including, a recording layer which is formed of the photosensitive composition according to any one of <1> to <10> above and which records information using holography.

<12> The optical recording medium according to <11> above, wherein the optical recording medium includes, in sequence, a first substrate, a selective reflection layer, a recording layer and a second substrate.

<13> The optical recording medium according to <12> above, wherein the selective reflection layer allows transmission of a first light and reflects a second light.

<14> A method for manufacturing an optical recording medium including, forming a recording layer using the photosensitive composition according to any one of <1> to <10> above, and heating at 30°C for 30 min or longer the entirety of an optical recording medium in which the recording layer has been formed.

<15> An optical recording method including, applying an information beam and a reference beam to the optical recording medium according to any one of <11> to <13> above so that the optical axis of the information beam is coaxial with that of the reference beam, and recording information in a recording layer in the form of interference pattern formed by interference of the information beam and the reference beam.

<16> An optical recording apparatus including, a light-irradiating unit which applies a coherent information beam and a coherent reference beam to the optical recording medium according to any one of <11> to <13> above so that the optical axis of the information beam is coaxial with that of the reference beam; and an interference pattern-recording unit which forms an interference pattern by interference of the information beam and the reference beam and which records the interference pattern in the optical recording medium.

The photosensitive composition of the present invention contains (A) a photoreactive material, (B) an epoxy compound having an average epoxy equivalent of 230 g/eq. or less and having two or more epoxy groups in the molecule thereof, and

(C) a thiol group-containing compound; and is used for forming a recording layer which records information using

holography. The present photosensitive composition is stable at high humidity, allows easy handling over time in a liquid state, does not require high temperature conditions for curing, contributes to rapid manufacture, and can be applied to various molding methods.

The optical recording medium of the present invention includes a recording layer which is formed of the present photosensitive composition and which records information using holography. Thus, the optical recording medium exhibits excellent sensitivity, multiplex recording performance and archivability; and is suitably applied to volume holographic recording.

According to the optical recording method of the present invention, an information beam and a reference beam are applied to the present optical recording medium so that the optical axis of the information beam is coaxial with that of the reference beam; and information is recorded in a recording layer in the form of interference pattern formed by interference of the information and reference beams. The present optical recording method using the present optical recording medium achieves sufficient signal intensity and sufficient multiplex recording performance at the same time by recording information in the recording layer in the form of interference pattern formed by interference of the information and reference beams. The present method, therefore, realizes high-density recording which has not yet been attained.

In an optical reproducing method in the present invention, information is reproduced by applying a reference beam to the interference pattern recorded in the recording layer by the present optical recording method. The present optical reproducing method realizes reproduction of recorded high-density information by efficiently, accurately reading the interference pattern recorded in the recording layer by the present recording method.

The optical recording apparatus of the present invention includes a light-irradiating unit which applies a coherent information beam and a coherent reference beam to the present optical recording medium so that the optical axis of the information beam is coaxial with that of the reference beam; and an interference pattern-recording unit which forms an interference pattern by interference of the information and reference beams, and which records the interference pattern in the optical recording medium. The present optical recording apparatus using the present optical recording medium achieves sufficient signal intensity and sufficient multiplex recording at the same time. The present apparatus, therefore, realizes high-sensitive optical multiplex recording.

## Brief Description of Drawings

FIG.1 is a schematic cross-sectional view of a conventional optical recording medium.

FIG.2 is a schematic cross-sectional view of another conventional optical recording medium.

FIG.3 is a schematic cross-sectional view of an exemplary optical recording medium of the present invention.

FIG.4 is a graph of reflectance of a filter with three cholesteric liquid crystal layers vs. wavelength of light incident perpendicularly to the filter (at an angle of 0°).

FIG.5 is a graph of reflectance of a filter with three cholesteric liquid crystal layers vs. wavelength of light incident at an oblique angle of 40°.

FIG.6 is a graph of reflectance of a filter with two cholesteric liquid crystal layers vs. wavelength of light incident perpendicularly to the filter (at an angle of 0°).

FIG.7 is a graph of reflectance of a filter with two cholesteric liquid crystal layers vs. wavelength of light incident at an oblique angle of 20°.

FIG.8 is a representation of an exemplary optical system surrounding an optical recording medium of the present invention.

FIG.9 is a block diagram exemplarily showing the entire configuration of an optical recording apparatus of the present invention.

## Best Mode for Carrying Out the Invention

### (Photosensitive composition)

A photosensitive composition of the present invention is used for forming a recording layer which records information using holography, and contains (A) a photoreactive material, (B) an epoxy compound having an average epoxy equivalent of 230 g/eq. or less and having two or more epoxy groups in the molecule thereof, and (C) a thiol group-containing compound and, if necessary, further contains other components.

Preferably, the epoxy compound (B) reacts with the thiol group-containing compound (C) to form a polymerized product (matrix).

<(A) Photoreactive material>

The photoreactive material contains at least a polymerizable compound and a polymerization initiator and, if necessary, further contains other components.

- Polymerizable compound -

The polymerizable compound is preferably radical polymerizable compounds. The radical polymerizable compounds may be used alone or in combination.

Examples of the radical polymerizable compounds include unsaturated carboxylic acids, and esters and amides thereof. Specifically, there are used esters formed between unsaturated carboxylic acids and polyhydric alcohol compounds, and amides formed between unsaturated carboxylic acids and polyamine compounds. Examples of the unsaturated carboxylic acid include acrylic acid, methacrylic acid, itaconic acid, crotonic acid, isocrotonic acid and maleic acid.

In addition, preferred are addition products formed between esters or amides of unsaturated carboxylic acids having a nucleophilic substituent (e.g., a hydroxyl group or an aminecarboncapto group) and monofunctional or polyfunctional isocyanates or epoxies; and dehydration-condensation products formed between the esters or amides and monofunctional or polyfunctional carboxylic acids.

In addition, preferred are addition products formed between esters or amides of unsaturated carboxylic acids having an electrophilic substituent (e.g., an isocyanate group or an epoxy group) and monofunctional or polyfunctional alcohols, amines or thiols.

In addition, preferred are substituted products formed from esters or amides of unsaturated carboxylic acids having a substituent (e.g., halogen) and monofunctional or polyfunctional alcohols, amines or thiols.

Notably, there can be used compounds obtained by replacing the unsaturated carboxylic acids with unsaturated phosphonic acids, styrene, etc.

Specific examples of the esters (monomers) formed between unsaturated carboxylic acids and polyhydric alcohol compounds include acrylate esters, methacrylate esters, itaconate esters, crotonate esters, isocrotonate esters, maleate esters and other esters.

Examples of the acrylate ester include ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, polyesteracrylate oligomer, isocyanuric acid EO-modified triacrylate, benzylacrylate, 2-phenoxyethyl acrylate, naphthylacrylate, isobornyl acrylate and tribromophenyl acrylate.

Examples of the methacrylate ester include tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate bis[p-(3-methacryloxy-2-hydroxypropoxy)phenyl]dimethylmethane and bis-[p-( methacryloxyethoxy)phenyl]dimethylmethane.

Examples of the itaconate ester include ethylene glycol diitaconate, propylene glycol diitaconate, 1,3-butanediol diitaconate, 1,4-butanediol diitaconate, tetramethylene glycol diitaconate, pentaerythritol diitaconate and sorbitol tetraitaconate.

Examples of the crotonate ester include ethylene glycol dicrotonate, tetramethylene glycol dicrotonate, pentaerythritol dicrotonate and sorbitol tetradicrotonate.

Examples of the isocrotonate ester include ethylene glycol diisocrotonate, pentaerythritol diisocrotonate and sorbitol tetraisocrotonate.

Examples of the maleate ester include ethylene glycol dimaleate, triethylene glycol dimaleate, pentaerythritol dimaleate and sorbitol tetramaleate.

Examples of the other esters include esters having a 9,9-diarylfluorene skeleton described in Japanese Patent (JP-B) No. 2849021; siloxane bond-containing (meth)acrylates described in JP-A No. 08-101499 and JP-B No. 3532679; biphenyl-containing (meth)acrylates described in JP-A 2001-125474; and oligomeric (meth)acrylates described in JP-A Nos. 07-199777, 07-199779 and 07-104643.

In addition, styrene and similar compounds are preferably used. Examples include bromostyrene, dibromostyrene, vinylnaphthalene, alkoxystyrenes, divinylbenzene, thio ether moiety-containing styrene and vinylnaphthalene derivatives. These compounds may be used alone or in combination. Particularly preferred is 1-(3-naphth-1-ylthio)propylthio)naphthalene.

The polymerizable compound content is preferably 1% by mass to 40% by mass, more preferably 2% by mass to 30% by mass, particularly preferably 3% by mass to 25% by mass, based on the total solid content of the photosensitive composition. When the content falls within the above ranges, the formed photosensitive composition exhibits excellent sensitivity, multiplex recording performance and archivability. When the content is less than 1% by mass, sufficient sensitivity and multiplex recording performance to be applied to volume holography may not be obtained, whereas when the content is more than 40% by mass, archivability may be deteriorated. Furthermore, resolution may be deteriorated, resulting in recording failure.

- Polymerization initiator -

The polymerization initiator is not particularly limited, and various polymerization-initiating systems known in the art can be employed. The polymerization-initiating system may be a system consisting of a single compound or two or more different compounds, and is preferably capable of activating radical polymerization.
Examples of the compound constituting the photoradical polymerization-initiating system include organic halide compounds, carbonyl compounds, organic peroxide compounds, azo polymerization initiators, azide compounds, metalocene compounds, hexaarylbiimidazole compounds, organic boric acid compounds, disulfonic acid compounds, oxime ester compounds and onium salt compounds.
Specific examples of the organic halide compound include compounds described in Wakabayashi, et al., "Bull Chem. Soc. Japan", 42, 2924 (1969), specification of U.S. Pat. No. 3,905,815, Japanese Patent Application Publication (JP-B) No. 46-4605, JP-A Nos. 48-36281, 55-32070, 60-239736, 61-169835, 61-169837, 62-58241, 62-212401, 63-70243, and 63-298339, and M. P. Hutt, "Journal of Heterocyclic Chemistry", 1 (No. 3), (1970). Among these compounds, oxazole compounds and S-triazine compounds having a trihalomethyl group as a substituent are particularly preferred.
More preferred are s-triazine derivatives in which at least one mono-, di- or tri-halogen-substituted methyl group is bonded to an s-triazine ring. Specific examples thereof include 2,4,6-tris(monochloromethyl)-s-triazine, 2,4,6-tris (dichloromethyl)-s-triazine, 2,4,6-tris(trichloromethyl)-s-triazine, 2-methyl-4,6-bis(trichloromethyl)-s-triazine, 2-n-propyl-4,6-bis(trichloromethyl)-s-triazine, 2-(α,α,β-trichloroethyl)-4,6-bis(trichloromethyl)-s-triazine, 2-phenyl-4,6-bis(trichloromethyl)-s-triazine, 2-(p-methoxyphenyl)-4,6-bis(trichloromethyl)-s-triazine, 2-(3,4-epoxyphenyl)-4,6-bis(trichloromethyl)-s-triazine, 2-(p-chlorophenyl)-4,6-bis(trichloromethyl)-s-triazine, 2-[1-(p-methoxyphenyl)-2,4-butadienyl]-4,6-bis (trichloromethyl)-s-triazine, 2-styryl-4,6-bis(trichloromethyl)-s-triazine, 2-(p-methoxystyryl)-4,6-bis(trichloromethyl)-s-triazine, 2-(p-i-propyloxystyryl)-4,6-bis(trichloromethyl)-s-triazine, 2-(p-tollyl)-4,6-bis(trichloromethyl)-s-triazine, 2-(4-natoxynaphthyl)-4,6-bis(trichloromethyl)-s-triazine, 2-phenylthio-4,6-bis(trichloromethyl)-s-triazine, 2-benzylthio-4,6-bis (trichloromethyl)-s-triazine, 2,4,6-tris(dibromomethyl)-s-triazine, 2,4,6-tris(tribromomethyl)-s-triazine, 2-methyl-4,6-bis (tribromomethyl)-s-triazine and 2-methoxy-4,6-bis(tribromomethyl)-s-triazine.
Examples of the carbonyl compound include benzophenone; benzophenone derivatives such as Michler's ketone, 2-methylbenzophenone, 3-methylbenzophenone, 4-methylbenzophenone, 2-chlorobenzophenone, 4-bromobenzophenone and 2-carboxybenzophenone; acetophenone derivatives such as 2,2-dimethoxy-2-phenylacetophenone, 2,2-diethoxyacetophenone, 1-hydroxycyclohexylphenylketone, α-hydroxy-2-methylphenylpropanone, 1-hydroxy-1-methylethyl-(p-isopropylphenyl)ketone, 1-hydroxy-1-(p-dodecylphenyl)ketone, 2-methyl-(4'-(methylthio)phenyl)-2-morpholino-1-propanone and 1,1,1-trichloromethyl-(p-butylphenyl)ketone; thioxanthone; thioxanthone derivatives such as 2-ethylthioxanthone, 2-isopropylthioxanthone, 2-chlorothioxanthone, 2,4-dimethylthioxanthone, 2,4-diethylthioxanthone and 2,4-diisopropylthioxanthone; and benzoate derivatives such as ethyl p-dimethylaminobenzoate and ethyl p-diethylaminobenzoate.
Examples of the azo compound which can be used include those described in JP-A No. 08-108621.
Examples of the organic peroxide compound include trimethylcyclohexanone peroxide, acetylacetone peroxide, 1,1-bis(tert-butylperoxy)-3,3,5-trimethylcyclohexane, 1,1-bis(tert-butylperoxy)cyclohexane, 2,2-bis(tert-butylperoxy)butane, tert-butyl hydroperoxide, cumene hydroperoxide, diisopropylbenzene hydroperoxide, 2,5-dimethylhexane-2,5-dihydroperoxide, 1,1,3,3-tetramethylbutyl hydroperoxide, tert-butylcumyl peroxide, dicumyl peroxide, 2,5-dimethyl-2,5-di (tert-butylperoxy)hexane, 2,5-oxanoyl peroxide, succinic acid peroxide, benzoyl peroxide, 2,4-dichlorobenzoyl peroxide, diisopropyl peroxydicarbonate, di-2-ethylhexyl peroxydicarbonate, di-2-ethoxyethyl peroxydicarbonate, dimethoxyisopropyl peroxycarbonate, di(3-methyl-3-methoxybutyl)peroxydicarbonate, tert-butylperoxy acetate, tert-butylperoxy pivalate, tert-butylperoxy neodecanoate, tert-butylperoxy octanoate, tert-butylperoxy laurate, tertiary carbonate, 3,3',4,4'-tetra-(t-butylperoxycarbonyl)benzophenone, 3,3',4,4'-tetra-(t-hexylperoxycarbonyl)benzophenone, 3,3',4,4'-tetra-(p-isopropylcumylperoxycarbonyl)benzophenone, carbonyldi(t-butylperoxy dihydrogen diphthalate) and carbonyldi(t-hexylperoxy dihydrogen diphthalate).
Examples of the metalocene compound include various titanocene compounds described in JP-A Nos. 59-152396, 61-151197, 63-41484, 02-249, 02-4705 and 05-83588; e.g., di-cyclopentadienyl-Ti-bis-phenyl, di-cyclopentadienyl-Ti-bis-2,6-difluoropheny-1-yl, di-cyclopentadienyl-Ti-bis-2,4-di-fluoropheny-1-yl, di-cyclopentadienyl-Ti-bis-2,4,6-triffuoropheny-1-yl, di-cyclopentadienyl-Ti-bis-2,3,5,6-tetrafluoropheny-1-yl, di-cyclopentadienyl-Ti-bis-2,3,4,5,6-pentafluoropheny-1-yl, di-methylcyclopentadienyl-Ti-bis-2,6-difluoropheny-1-yl, di-methylcyclopentadienyl-Ti-bis-2,4,6-trifluoropheny-1-yl, di-methylcyclopentadienyl-Ti-bis-2,3,5,6-tetrafluoropheny-1-yl, di-methylcyclopentadienyl-Ti-bis-2,3,4,5,6-pentafluoropheny-1-yl and iron-allene complexes described in JP-A Nos. 01-304453 and 01-152109.

Examples of the hexaaryl biimidazole compound include various compounds described in, for example, JP-B No. 06-29285, specifications of U.S. Pat. Nos. 3,479,185, 4,311,783 and 4,622,286; e.g., 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(o,p-dichlorophenyl)-4,4',5,5'-tetraphenylbiimidazole, 2,2'-bis(o-chlorophenyl)-4,4',5,5'-tetra(m-methoxyphenyl)biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole and 2,2'-bis(o-trifluorophenyl)-4,4',5,5'-tetraphenylbiimidazole.

Examples of the organic borate compound include organic borate salts as described in JP-A Nos. 62-143044, 62-150242, 09-188685, 09-188686, 09-188710, 2000-131837 and 2002-107916, JP-B No. 2764769, and Kunz, Martin, "Rad Tech '98. Proceedings April 19-22", 1998, Chicago"; organic boron-sulfonium complexes or organic boron-oxosulfonium complexes as described in JP-A Nos. 06-157623, 06-175564 and 06-175561; organic boron-iodonium complexes as described in JP-A Nos. 06-175554 and 06-175553; organic boron-phosphonium complexes as described in JP-A No. 09-188710; and organic boron-transition metal coordinated complexes as described in JP-A Nos. 06-348011, 07-128785, 07-140589, 07-306527 and 07-292014.

Examples of the disulfone compound include compounds as described in JP-A Nos. 61-166544 and 2002-328465.

Examples of the oxime ester compound include compounds as described in J. C. S. Perkin II (1979) pp. 1653-1660, J. C. S. Perkin II (1979) pp. 156-162, Journal of Photopolymer Science and Technology (1995) pp. 202-232, and JP-A Nos. 2000-66385 and 2000-80068. Specific compounds are shown below.

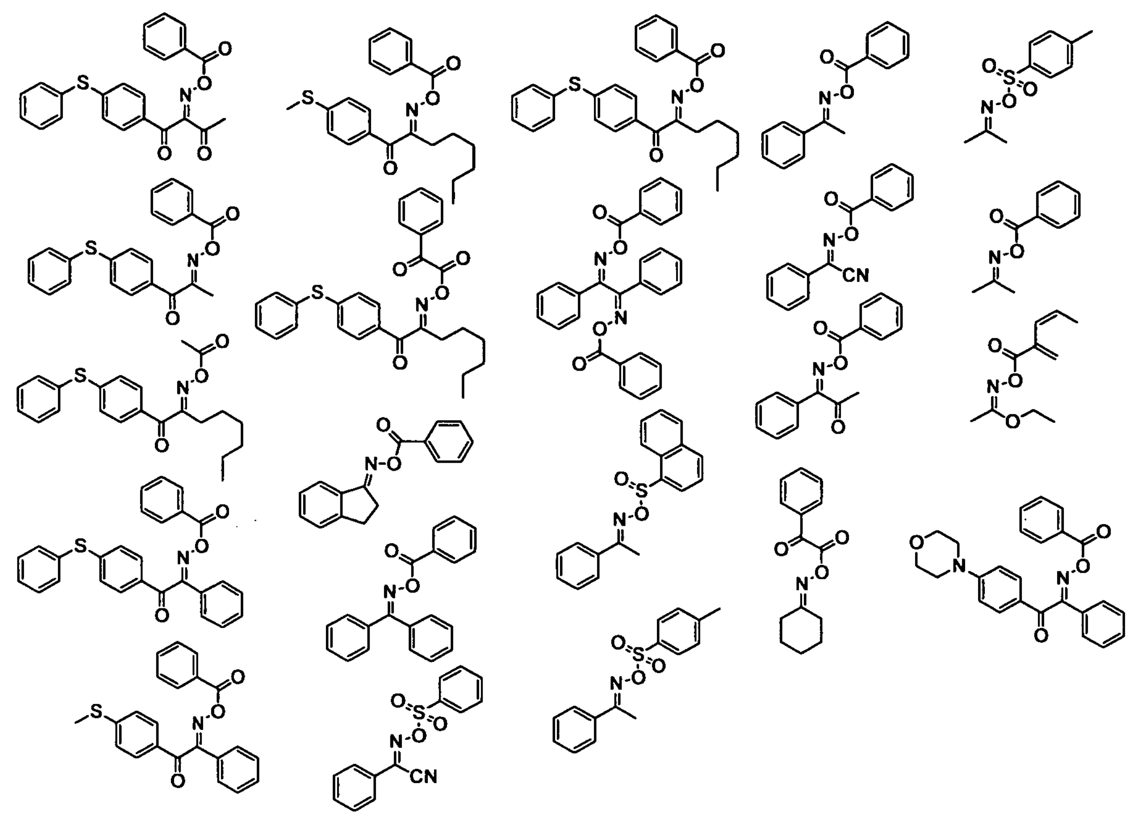

Examples of the onium salt compound include diazonium salts as described in S. I. Schlesinger, "Photogr. Sci. Eng.", 18, 387 (1974) and T. S. Bal et al. "Polymer", 21, 423 (1980); ammonium salts as described in specifications of U.S. Pat. No. 4,069,055 and JP-A No. 4-365049; phosphonium salts as described in specifications of U.S. Pat. Nos. 4,069,055 and 4,069,056; iodonium salts as described in specifications of European Pat. No. 104,143, specifications of U.S. Pat. Nos. 339,049 and 410,201, JP-A Nos. 02-150848 and 02-296514; sulfonium salts as described in specifications of European Pat. Nos. 370,693, 390,214, 233,567, 297,443 and 297,442, specifications of U.S. Pat. Nos. 4,933,377,

161,811, 410,201, 339,049, 4,760,013, 4,734,444 and 2,833,827, and specifications of Germany Pat. Nos. 2,904,626, 3,604,580 and 3,604,581; selenonium salts as described in J. V Crivello et al., "Macromolecules", 10 (6), 1307 (1977) and J. V. Crivello et al., "J. Polymer Sci., Polymer Chem. Ed.", 17, 1047 (1979); and arsonium salts as described in C. S. Wen et al., "Teh, Proc. Conf. Rad. Curing ASIA", p. 478, Tokyo, Oct. (1988).

Among these compounds, from the viewpoints of reactivity and stability, oxime ester compounds, diazonium salts, iodonium salts and sulfonium salts are particularly preferred.

In order to further sensitize the polymerization initiator, a sensitizer may be added. Examples of the sensitizer include coumarins having a substituent(s) at position(s) 3 and/or 7, flavones, dibenzalacetones, dibenzalcyclohexanes, chalcones, xanthenes, thioxanthenes, porphyrins, phthalocyanines, acridines and anthracenes.

The photopolymerization initiator content is preferably 0.1% by mass to 10% by mass, more preferably 1% by mass to 7% by mass, particularly preferably 1.5% by mass to 5% by mass, based on the total solid content of the photosensitive composition. When the content is less than 0.1% by mass, sufficient sensitivity may not be obtained, whereas when the content is more than 10% by mass, a reference or information beam is unnecessarily absorbed, resulting in failure to obtain sufficient signal intensity to be read.

<(B) Epoxy compound having an average epoxy equivalent of 230 g/eq. or less and having two or more epoxy groups in the molecule thereof>

The epoxy compound (component (B)) is not particularly limited, so long as it has an average epoxy equivalent of 230 g/eq. or less and has two or more epoxy groups in the molecule thereof, and can be appropriately selected depending on the purpose. The epoxy compound may be monomers or oligomers of epoxy group-containing compounds. Examples thereof include aromatic epoxides, alicyclic epoxides and aliphatic epoxides.

The component (B) epoxy compound preferably has an average epoxy equivalent of 200 g/eq. or less, and the lower limit thereof is preferably 100 g/eq. The average epoxy equivalent is the amount (g) of an epoxy compound required that the compound contains one equivalent of epoxy group. Compounds having a lower average epoxy equivalent contain more epoxy groups on the weight basis, and exhibit higher reactivity. The compounds with an epoxy average equivalent more than 230 g/eq. are not easy to cure spontaneously and thus, require heating or other treatments for curing. The compounds with an epoxy average equivalent less than the lower limit generally are volatile, potentially not allowing easy handling.

The average epoxy equivalent can be determined according to, for example, JIS K7236, or by a usual measuring method such as the HCl-pyridine titration method, the HCl-dioxane titration method or the perchloric acid method.

Examples of the aromatic epoxide include diglycidyl ethers and polyglycidyl ethers produced by reacting epichlorhydrin with polyhydric phenols having at least one benzene nucleus or alkylene oxide adducts thereof. Specific examples include diglycidyl ethers and polyglycidyl ethers produced using bisphenol A or alkylene oxide adducts thereof; and diglycidyl ethers, polyglycidyl ethers, novolac epoxy resins produced using hydrogenated bisphenol A or alkylene oxide adducts thereof.

Examples of the alkylene oxide include ethylene oxide and propylene oxide, with ethylene oxide being particularly preferred.

Examples of the alicyclic epoxide include cyclohexene oxide-containing compounds and cyclopentene oxide-containing compounds produced by epoxidizing compounds containing at least one cycloalkane (e.g., cyclohexene and cyclopentene) with an appropriate oxidizing agent (e.g., hydrogen peroxide or peroxy acid). Specific examples thereof include compounds described below.

Examples of the aliphatic epoxide include diglycidyl ethers and polyglycidyl ethers produced using aliphatic polyhydric alcohols or alkylene oxide adducts thereof. Typical examples thereof include diglycidyl ethers produced using alkylene glycols (e.g., ethylene glycol, propylene glycol and 1,6-hexanediol); polyglycidyl ethers produced using polyhydric alcohols (e.g., diglycidyl ethers and polyglycidyl ethers produced using glycerin or alkylene oxide adducts thereof); and diglycidyl ethers produced using polyalkylene glycols (e.g., diglycidyl ethers produced using polyethylene glycols or alkylene oxide adducts thereof; and diglycidyl ethers produced using polypropylene glycols or alkylene oxide adducts thereof). Examples of the alkylene oxide include ethylene oxide and propylene oxide, with ethylene oxide being particularly preferred.

These may be used alone or in combination. Among these compounds, those having an ethylene oxide moiety are preferred, since no coloring occurs during laser beam irradiation.

<(C) Thiol group-containing compound>

Examples of preferred thiol group-containing compound include mercapto compounds. The mercapto compounds preferably have two or more functionalities from the viewpoint of imparting mechanical strength to the formed photosensitive composition. The mercapto compound is not particularly limited and can be appropriately selected depending on the purpose. Examples thereof include polymercaptan compounds derived from, for example, addition reaction between an excessive amount of low-molecular-weight dimercaptans and polyepoxide compounds; from reaction between polyepoxides and hydrogen sulfide; and from esterification between polyhydric alcohols and mercaptopropionic acid or mercaptoglycolic acid. The polymercaptan compounds preferably have an ethylene oxide moiety, since no coloring occurs during laser beam irradiation.

Examples of the dimercaptan include dimercaptoethane, dimercaptobutane, dimercaptohexane and dimercaptooctane.

Examples of the polyepoxide compound include bisphenol A and hydrogenated products thereof; epoxy-ended polyethylene glycol-modified products of glycerol, trimethylolpropane, pentaerythritol and dipentaerythritol, epoxy-ended polyethylene glycol-modified products of phthalic acid, terephthalic acid, isophthalic acid, trimellitic acid, pyromellitic acid and hydrogenated products of any of these aromatic polycarboxylic acids; and polypropylene glycol-modified products of any of these aromatic polycarboxylic acids.

Examples of the polyhydric alcohol include glycerol, trimethylolpropane, pentaerythritol, dipentaerythritol; OH-ended polyethylene glycol-modified products formed using phthalic acid, terephthalic acid, isophthalic acid, trimellitic acid and pyromellitic acid; and polypropylene glycols. Among these, preferred are the following compounds: trimercapto compounds derived from trimethylolpropane and dimercaptoethane; tetramercapto compounds derived from pentaerythritol and dimercaptoethane; trimercapto compounds derived from trimellitic acid and dimercaptoethane; trimercapto compounds derived from trimethylolpropane and mercaptopropionic acid; tetramercapto compounds derived from pentaerythritol and mercaptopropionic acid; trimercapto compounds derived from mercaptopropionic acid and polyethylene glycol-modified products of trimethylolpropane; and tetramercapto compounds derived from mercaptopropionic acid and polyethylene glycol-modified products of pentaerythritol.

The total amount of the epoxy compound (component (B)) and the thiol group-containing compound (component (C)) contained in the photosensitive composition is preferably 60% by mass to 99% by mass, more preferably 70% by mass to 95% by mass, still more preferably 75% by mass to 90% by mass, based on the total solid content by mass of the composition. When the total amount of these components falls within the above ranges, the formed photosensitive composition exhibits excellent sensitivity, multiplex recording performance and archivability. When the total amount is in excess of 99% by mass, sufficient sensitivity and multiplex recording performance to be applied to volume holography may not be obtained, whereas when the total amount is less than 60% by mass, archivability may be deteriorated.

Mixing ratio by mass of the component (B) epoxy compound to the component (C) compound (component (B) : component (C)) is determined using the epoxy equivalent of the epoxy compound employed (component (B)) and the thiol equivalent or amine equivalent of the component (C). When x (g/eq.) denotes the epoxy equivalent of the epoxy compound (B) and y (mol/g) denotes the thiol or amine equivalent of the component (C) compound, the following relationship: (amount by mass of component (B)) = $x \times y \times$ (amount by mass of component (C)) is stoichiochemically preferably satisfied. If necessary, the amount by mass of the component (C), which is a right-hand member, is allowed to increase or decrease in some degree from a stoichiometric value determined based on this relationship. The span of the increase or decrease is preferably 0.7 to 1.2 times the stoichiometric value, more preferably 0.8 to 1.1 times.

In the case where the amount by mass of the component (C) is optimized within the above ranges, even when the amount is not necessarily equal to the stoichiometric value, the formed photosensitive composition can provide a cured product having excellent mechanical characteristics such as flexural strength, tensile strength, yield point, dimensional stability and weatherability. When the amount is deviated from the above ranges, the mechanical characteristics of the cured product may be impaired. Notably, the thiol or amine equivalent can be stoichiometrically determined, when a known compound is used. Meanwhile, when an unknown compound or a mixture is used, the amine equivalent can be determined by the measuring method stipulated in JIS K7237-1986 (the perchloric acid titration method); and the thiol equivalent can be determined as follows: after reaction with an epoxy compound having a known epoxy value, the reaction product is analyzed by Fourier transform infrared spectroscopy for the amount (or number) of the reacted functional groups.

- Curing promoter -

Preferably, the photosensitive composition further contains a curing promoter.

Examples of the curing promoter include tertialy alkylamines, tertialy aromatic amines and tertialy alicyclic amines.

Examples of the tertialy alkylamine include triethylamine, tributylamine, diisopropylethylamine and triethanolamine.

Examples of the tertialy aromatic amine include tris-2,4,6-(dimethylaminomethyl)phenol and dimethylbenzylamine.

Examples of the tertialy alicyclic amine include hexamethylenetetramine, diazabicycloundecane (DBU) and diazabicyclooctane (DABCO).

The curing promoter content is preferably 0.1% by mass to 10% by mass, more preferably 1% by mass to 7% by mass, still more preferably 1.5% by mass to 5% by mass, based on the total solid content by mass of the photosensitive composition. When the content falls within the above ranges, the photosensitive composition exhibits rapid curing performance and provides a cured product having excellent mechanical characteristics.

In the photosensitive composition of the present invention, a mixture of the component (B) epoxy compound and the component (C) compound preferably turns into a gel within 30 min after heating to 30°C (preferably 10 min to 30 min, more preferably 15 min to 25 min). Determination as to whether or not the mixture of the component (B) epoxy compound and the component (C) compound turns into a gel can be carried out by, for example, any of the following methods: a method in which the mixture is analyzed for viscosity, and the obtained viscosity is judged as to whether or not it exceeds a value within a viscosity range of common liquid; and a method in which after being subjected to a gelling treatment, the mixture is immersed in an appropriate solvent (which is capable of dissolving component (B) and component (C)), followed by measuring of percent insoluble matter (on the weight basis).

The mixture of the component (B) epoxy compound and the component (C) thiol group-containing compound preferably spontaneously exhibits an exothermic peak within 30 min after mixing (preferably 12 min to 30 min, more preferably 15 min to 25 min). Determination as to whether or not the mixture spontaneously exhibits an exothermic peak is carried out by, for example, a method in which a small amount of the mixture (containing the component (B) epoxy compound and the component (C) thiol group-containing compound) is placed in an aluminum pan, and then the mixture is analyzed by thermogravimetry-differential thermal analysis (TG/TDA) or differential scanning calorimetry (DSC) for calorific value and a period of time required for reaching an exothermic peak.

The photosensitive composition preferably has a water content as measured by the Karl Fischer's method of 0.01% by mass to 2.5% by mass, more preferably 0.02% by mass to 2.0% by mass. The lower limit of the water content is not particularly limited. Meanwhile, when the water content is more than 2.5% by mass, the component (B) may be hydrolyzed as time passes. In addition, the formed cured product may have a large amount of water and be lack of environmental stability.

The photosensitive composition of the present invention is used for forming a recording layer which records information using holography. The present composition is particularly suitably used in, for example, an optical recording medium of the present invention, a method for manufacturing an optical recording medium of the present invention, an optical recording method of the present invention and an optical recording apparatus of the present invention.

(Optical recording medium)

An optical recording medium of the present invention is formed form the photosensitive composition of the present invention. The present optical recording medium includes, in sequence, a first substrate, a selective reflection layer, a recording layer which records information using holography, and a second substrate and, if necessary, includes other layers.

The optical recording medium of the present invention is not particularly limited, so long as it is recordable and reproducible based on the principles of hologram. The optical recording medium may record a relatively thin, flat hologram which is employed for recording, for example, two-dimensional information; or may record a volume hologram which is employed for recording a large volume of information (e.g., stereoimages). Also, the optical recording medium may be of transmission type or reflection type. In addition, the method by which a hologram is recorded may be any method, and the formed hologram may be, for example, an amplitude hologram, a phase hologram, a blazed hologram, a complex amplitude hologram.

The thickness of the recording layer is not particularly limited and can be appropriately selected depending on the purpose. The thickness is preferably 100 μm to 1,000 μm, more preferably 150 μm to 700 μm, still more preferably 200 μm to 500 μm. When the thickness falls within the above ranges, highly efficient manufacture and excellent volume holographic optical recording can be attained. When the thickness is in excess of 1,000 μm, difficulty may be encountered from the viewpoints of elevating manufacturing cost and requiring cumbersome processes, whereas when the thickness is less than 100 μm, desired signal intensity and desired multiplex recording performance may not be obtained at the same time.

<Substrate>

The shape, structure, size, etc. of the substrate are not particularly limited and can be appropriately selected depending on the purpose. The substrate has a shape of, for example, disc, flat card or sheet. The structure of the substrate may be a single-layer structure or a laminated structure. The size thereof may be appropriately determined in consideration of the size of an intended optical recording medium, or other factors.

The material used for the substrate is not particularly limited, so long as it ensures the mechanical strength of an optical recording medium, and an inorganic or organic material is preferably used. In manufacturing an optical recording

medium of transmission type, in which recording and reproducing beams enter through a substrate, the substrate material must exhibit sufficient transparency with respect to light employed.

Examples of the inorganic material include glass, quartz and silicon.

Examples of the organic material include acetate resins (e.g., triacetyl cellulose), polyester resins, polyether sulfone resins, polysulfone resins, polycarbonate resins, polyamide resins, polyimide resins, polyolefin resins, acrylic resins, polynorbornene resins, cellulose resins, polyarylate resins, polystyrene resins, polyvinyl alcohol resins, polyvinyl chloride resins, polyvinylidene chloride resins, polyacrylic resins, polylactic acid resins, plastic film laminated paper and synthetic paper. These materials may be used alone or in combination. Of these, from the viewpoints of moldability, optical properties and cost, polycarbonate resins and acrylic resins are preferred.

The substrate may be appropriately synthesized or may be commercially available one. The thickness of the substrate is not particularly limited and can be appropriately determined depending on the purpose. The thickness is preferably 0.1 mm to 5 mm, more preferably 0.3 mm to 2 mm. When the thickness is less than 0.1 mm, generation of disc deformation during storage cannot be prevented, whereas when the thickness is in excess of 5 mm, the total weight of the disc increases, resulting in that when, in use, the disc is rotated by a drive motor or a similar device, an excessive load may be applied.

The substrate is provided, on a surface thereof, with a plurality of address-servo areas at predetermined angle intervals, which serve as a positioning area and extend linearly in the radial direction, and fan-shaped areas between adjacent address-servo areas are a data area. In the address-servo areas, address information and information for carrying out focus servo control and tracking servo control by a sampled servo method are recorded in advance (pre-formatted) in the form of embossed pits (servo pits). The focus servo can be controlled using the reflection surface of a reflective film. The information for carrying out tracking servo control may be, for example, wobble pits.

- Reflective film -

The reflective film is formed on the surface of the servo pit pattern in the substrate.

The reflective film is preferably formed of a material having high reflectance with respect to a recording beam and a reference beam. When light with a wavelength of 400 nm to 780 nm is used, the film is preferably formed of, for example, Al, Al alloys, Ag or Ag alloys. When light with a wavelength of 650 nm or more, the film is preferably formed of, for example, Al, Al alloys, Ag, Ag alloys, Au, Cu alloys or TiN.

Using, as a reflective film, an optical recording medium (e.g., a DVD (digital video disc)) which reflects light and is capable of carrying out information-recording or information-erasing, directory information, which is in relation to, for example, up to which area a hologram is recorded, when holographic images are rewritten, where an error resides and how a replacement processing is carried out, can be recorded or rewritten without affecting holograms.

The method for forming the reflective film is not particularly limited and can be appropriately selected depending on the purpose. Examples of the method include various vapor deposition methods such as vacuum deposition methods, spattering methods, plasma CVD methods, photo-CVD methods, ion plating methods and electron beam deposition methods. Of these, spattering methods are preferred, from the viewpoints of improving, for example, mass-productivity and film quality.

The thickness of the reflective film is preferably 50 nm or more, more preferably 100 nm or more, for the purpose of ensuring sufficient reflectance.

<Selective reflection layer>

The selective reflection layer is formed on the servo pits in the substrate or on the reflective layer.

The selective reflection layer has the function of reflecting only light with a specific wavelength contained in those with different wavelengths; i.e., reflecting light wavelength-selectively. In addition, since the selective reflection layer can reflect light even when the incident angle of the light is changed, this layer has the function of preventing occurrence of noise by blocking an information or reference beam diffused on the reflective film of the optical recording medium. Thus, a selective reflection layer-containing optical recording medium exhibits optical recording performance having high resolution and high diffraction efficiency.

The type of the selective reflection layer is not particularly limited and can be appropriately selected depending on the purpose. For example, the selective reflection layer is a laminated product formed by laminating at least any of a dichroic mirror layer, a coloring material-containing layer, a dielectric deposition layer, a single layer or two or more layers of cholesteric layer(s) and other layers appropriately selected in accordance with needs.

The selective reflection layer is formed by coating directly on the substrate together with, for example, the recording layer. Alternatively, the selective layer is separately formed on a base such as a film, and then the formed layer is laminated on the substrate.

- Dichroic mirror layer -

A plurality of dichroic mirror layers are laminated so as to exhibit wavelength-selective reflectivity. The number of layers to be laminated is preferably 1 to 50, more preferably 2 to 40, particularly preferably 2 to 30. When the number of the layers is greater than 50, production efficiency drops due to increased cycles of vapor deposition, and change in spectral transmittance becomes smaller. Thus, the effects sufficiently commensurate with the increased layers cannot be obtained.

The material for forming the dichroic mirror layer is not particularly limited and can be appropriately selected depending on the purpose. Examples thereof include Ag, Au, Pt, Al and alloys thereof.

The method for forming the dichroic mirror layer is not particularly limited and can be appropriately selected depending on the purpose. Examples of the method include physical vapor deposition (PVD) methods (e.g., vacuum vapor deposition methods, sputtering methods, ion plating methods, ion beam methods, ion-assisted deposition methods and laser ablation methods) and chemical vapor deposition (CVD) methods (e.g., thermal CVD methods, photo-CVD methods and plasma CVD methods). Of these, physical vapor deposition (PVD) methods are preferred, with sputtering methods being particularly preferred.

When sputtering is employed, DC sputtering is preferred since it exhibits high deposition rate. Notably, a highly conductive material is preferably used in DC sputtering.

The method for forming a laminated product having a plurality of layers by sputtering include: (1) a single-chamber method, in which film formation is carried out in a single chamber alternately or sequentially using two or more targets; and (2) a multi-chamber method, in which film formation is sequentially carried out using two or more chambers. Of these, the multi-chamber method is particularly preferred from the viewpoints of improving productivity and preventing material contamination.

The thickness of the dichroic mirror layer is on the order of optical wavelength, and is preferably $\lambda/16$ to $\lambda$, more preferably $\lambda/8$ to $3\lambda/4$, still more preferably $\lambda/6$ to $3\lambda/8$.

- Coloring material-containing layer -

The coloring material-containing layer is formed from a coloring material, a binder resin, a solvent and, if necessary, from other components.

The coloring material is preferably a pigment or a dye. Among these, since they absorb light of wavelength 532 nm and allow a servo beam of wavelength 655 nm or 780 nm to transmit, a red pigment and a red dye are preferred, with a red pigment being particularly preferred.

The red dye is not particularly limited and can be appropriately selected from known dyes depending on the purpose. Examples thereof include acidic dyes such as C. I. Acid Reds 1, 8, 13, 14, 18, 26, 27, 35, 37, 42, 52, 82, 87, 89, 92, 97, 106, 111, 114, 115, 134, 186, 249, 254 and 289; basic dyes such as C. I. Basic Reds 2, 12, 13, 14, 15, 18, 22, 23, 24, 27, 29, 35, 36, 38, 39, 46, 49, 51, 52, 54, 59, 68, 69, 70, 73, 78, 82, 102, 104, 109 and 112; and reactive dyes such as C. I Reactive Reds 1, 14, 17, 25, 26, 32, 37, 44, 46, 55, 60, 66, 74, 79, 96 and 97. These dyes may be used alone or in combination.

The red pigment is not particularly limited and can be appropriately selected from known pigments depending on the purpose. Examples thereof include C. I. Pigment Red 9, C. I. Pigment Red 97, C. I. Pigment Red 122, C. I. Pigment Red 123, C. I. Pigment Red 149, C. I. Pigment Red 168, C. I. Pigment Red 177, C. I. Pigment Red 180, C. I. Pigment Red 192, C. I. Pigment Red 209, C. I. Pigment Red 215, C. I. Pigment Red 216, C. I. Pigment Red 217, C. I. Pigment Red 220, C. I. Pigment Red 223, C. I. Pigment Red 224, C. I. Pigment Red 226, C. I. Pigment Red 227, C. I. Pigment Red 228, C. I. Pigment Red 240, C. I. Pigment Red 48:1, Permanent Carmine FBB (C. I. Pigment Red 146), Permanent Ruby FBH (C. I. Pigment Red 11) and Faster Pink B Supra (C. I. Pigment Red 81). These pigments may be used alone or in combination.

Among these red pigments, particularly preferred are those having a transmission spectrum in which the transmittance for light of wavelength 532 nm is 10% or less and the transmittance for light of wavelength 655 nm is 90% or more.

The coloring material content is preferably 0.05% by mass to 90% by mass, more preferably 0.1% by mass to 70% by mass, based on total solid content by mass of the coloring material-containing layer. When the content is less than 0.05% by mass, the thickness of the formed coloring material-containing layer must be 500 $\mu$m or more, whereas when the content is in excess of 90% by mass, the formed coloring material-containing layer has no self-supporting property and thus, may break during production thereof.

- Binder resin -

The binder resin is not particularly limited and can be appropriately selected from known resins depending on the purpose. Examples thereof include polyvinyl alcohol resins, vinyl chloride/vinyl acetate copolymers; copolymers of

vinyl chloride or vinyl acetate and at least any one of vinyl alcohol, malleic acid and acrylic acid; vinyl chloride/vinylidene chloride copolymers; vinyl chloride/acrylonitrile copolymers; ethylene/vinyl acetate copolymers; cellulose derivatives such as nitrocellulose; polyacrylic resins, polyvinyl acetal resins, polyvinyl butyral resins, epoxy resins, phenoxy resins, polyurethane resins and polycarbonate resins. These resins may be used alone or in combination.

In order to increase their dispersibility and durability, preferably, a polar group (e.g., an epoxy group, $CO_2H$, OH, $NH_2$, $SO_3M$, $OSO_3M$, $PO_3M_2$ or $OPO_3M_2$ (wherein M represents a hydrogen atom, an alkali metal or ammonium, and in the case of $PO_3M_2$ and $OPO_3M_2$, two Ms contained in these groups may be different from each other)) is preferably introduced into the molecule of any of the above-listed binder resins. The polar group content is preferably $10^{-6}$ to $10^{-4}$ equivalents per gram of the binder resin.

The binder resin(s) is preferably cured by addition of a known isocyanate crosslinking agent.

The binder resin content is preferably 10% by mass to 99.95% by mass, more preferably 30% by mass to 99.9% by mass, based on the total solid content by mass of the coloring material-containing layer.

The above-described components are dissolved or dispersed in an appropriate solvent to prepare a coating solution, and then the coating solution is applied on a substrate (described below) by a desired coating method, whereby a coloring material-containing layer is formed.

The solvent is not particularly limited and can be appropriately selected from known solvents depending on the purpose. Examples thereof include water, alkoxypropionate esters (e.g., methyl 3-methoxypropionate, ethyl 3-methoxypropionate, propyl 3-methoxypropionate, methyl 3-ethoxypropionate, ethyl 3-ethoxypropionate and propyl 3-ethoxypropionate); esters of alkoxy alcohols (e.g., 2-methoxypropylacetate, 2-ethoxypropylacetate and 3-methoxybutylacetate); lactate esters (e.g., methyl lactate and ethyl lactate); ketones (e.g., methyl ethyl ketone, cyclohexanone and methylcyclohexanone), $\gamma$-butyrolactone, N-methylpyrrolidone; dimethylsulfoxide, chloroform and tetrahydrofuran. These solvents may be used alone or in combination.

The coating method is not particularly limited and can be appropriately selected depending on the purpose. Examples thereof include an ink-jet method, a spin coating method, a kneader coating method, a bar coating method, a blade coating method, a casting method, a dipping method and a curtain coating method.

The thickness of the coloring material-containing layer is preferably 0.5 $\mu$m to 200 $\mu$m, more preferably 1.0 $\mu$m to 100 $\mu$m. If the thickness is adjusted to less than 0.5 $\mu$m, the binder resin, which encapsulates the coloring material to form a film, may not be incorporated in a sufficient amount. If the thickness is more than 200 $\mu$m, the formed filter becomes too thick, requiring, in some cases, a considerably large optical system for an irradiated beam and a servo beam.

- Dielectric deposition layer -

The dielectric deposition layer is, for example, a laminated product of a plurality of dielectric thin layers having different refractive indices. In order for the dielectric deposition layer to exhibit wavelength-selective reflectivity, it is preferably formed by alternately laminating high-refractive-index dielectric thin layers and low-refractive-index dielectric thin layers. There may be used dielectric thin layers different in a refractive index from any of these. The dielectric deposition layer is not limited to these types of layers, and other types of layers may be used.

The number of the dielectric thin layers laminated is preferably 2 to 20, more preferably 2 to 12, still more preferably 4 to 10, particularly preferably 6 to 8. When the number of the layers laminated is greater than 20, production efficiency drops due to the required number of vapor deposition and, in some cases, the objects and effects of the present invention cannot be achieved.

The order in which the dielectric thin layers are laminated is not particularly limited and can be appropriately determined depending on the purpose. For example, a dielectric thin layer having a high refractive index is provided on a dielectric thin layer having a refractive index lower than that of the layer; or a dielectric thin layer having a low refractive index is provided on a dielectric thin layer having a refractive index higher than that of the layer. The criterion for determining whether the refractive index of a dielectric thin layer is high or low is preferably 1.8. Notably, the high-refractive-index dielectric thin layer and the low-refractive-index dielectric thin layer are absolutely discriminated from each other. The high-refractive-index materials may contain a relatively high refractive index-material and a relatively low refractive index-material, and these materials may by alternately used.

The material for forming the high-refractive-index dielectric thin layer is not particularly limited and can be appropriately selected depending on the purpose. Examples thereof include $Sb_2O_3$, $Sb_2S_3$, $Bi_2O_3$, $CeO_2$, $CeF_3$, $HfO_2$, $La_2O_3$, $Nd_2O_3$, $Pr_6O_{11}$, $Sc_2O_3$, SiO, $Ta_2O_5$, $TiO_2$, TlCl, $Y_2O_3$, ZnSe, ZnS and $ZrO_2$. Among these, $Bi_2O_3$, $CeO_2$, $CeF_3$, $HfO_2$, SiO, $Ta_2O_5$, $TiO_2$, $Y_2O_3$ ZnSe, ZnS and $ZrO_2$ are preferred, with SiO, $Ta_2O_5$, $TiO_2$ $Y_2O_3$ ZnSe, ZnS and $ZrO_2$ being more preferred.

The material for forming the low-refractive-index dielectric thin layer is not particularly limited and can be appropriately selected depending on the purpose. Examples thereof include $Al_2O_3$, $BiF_3$, $CaF_2$, $LaF_3$, $PbCl_2$, $PbF_2$, LiF, $MgF_2$, MgO, $NdF_3$, $SiO_2$, $Si_2O_3$, NaF, $ThO_2$ and $ThF_4$. Among these, $Al_2O_3$, $BiF_3$, $CaF_2$, $MgF_2$, MgO, $SiO_2$ and $Si_2O_3$ are preferred, with $Al_2O_3$, $CaF_2$, $MgF_2$, MgO, $SiO_2$ and $Si_2O_3$ being more preferred.

Notably, the atomic ratio in the material for the dielectric thin layer is not particularly limited and can be appropriately selected depending on the purpose. The atomic ratio can be adjusted by varying the atmosphere gas concentration during deposition.

The method for forming the dielectric thin layer is not particularly limited and can be appropriately selected depending on the purpose. Examples of the method include vacuum vapor deposition methods (e.g., ion plating and ion beam), physical vapor deposition (PVD) methods (e.g., sputtering) and chemical vapor deposition (CVD) methods. Of these, vacuum vapor deposition methods and sputtering are preferred, with sputtering being more preferred. When sputtering is employed, DC sputtering is preferred since it exhibits high deposition rate. Notably, a highly conductive material is preferably used in DC sputtering.

The method for forming a laminated product of a plurality of layers by sputtering include: (1) a single-chamber method, in which film formation is carried out in a single chamber alternately or sequentially using two or more targets; and (2) a multi-chamber method, in which film formation is sequentially carried out using two or more chambers. Of these, the multi-chamber method is particularly preferred from the viewpoints of improving productivity and preventing material contamination.

The thickness of the dielectric thin layer is on the order of optical wavelength, and is preferably $\lambda/16$ to $\lambda$, more preferably $\lambda/8$ to $3\lambda/4$, still more preferably $\lambda/6$ to $3\lambda/8$.

Some portion of light traveling through the dielectric deposition layer is reflected on each dielectric thin layer (i.e., reflected at many times), and the reflected beams interfere with one another. Thus, the dielectric deposition layer allows selective transmission of light having a wavelength determined by multiplying the thickness of the dielectric thin layer by the refractive index thereof. In addition, the central wavelength of light whose transmission is allowed by the dielectric deposition layer depends on the angle at which the light is incident thereinto, and thus, the wavelength of the light can be varied by changing the incident angle.

- Cholesteric liquid crystal layer -

The cholesteric liquid crystal layer contains at least a nematic liquid crystal compound and a chiral compound and, if necessary, further contains a polymerizable compound and other components.

A single cholesteric liquid crystal layer may be used. Alternatively, a laminated product of two or more cholesteric liquid crystal layers may be used. The number of the cholesteric liquid crystal layers laminated is not particularly limited and can be appropriately selected depending on the purpose. For example, the number of the layers laminated is preferably 2 to 10. When the number of the layers laminated is greater than 10, production efficiency drops and, in some cases, the objects and effects of the present invention cannot be achieved.

The cholesteric liquid crystal layer preferably has a circularly polarizing function. The cholesteric liquid crystal layer selectively reflects light components which have been circularly polarized in a direction in which a liquid crystal helix rotates (i.e., to the right or left) and which have a wavelength that equals to the pitch of the liquid crystal helix. Using this selective reflection characteristics, the cholesteric liquid crystal layer separates (transmits), from natural light having different wavelengths, a circularly polarized light component having a specific wavelength, and reflects the other light components. The cholesteric liquid crystal layer preferably allows transmission of a first circularly polarized light and reflects a second circularly polarized light which is different from the first circularly polarized light. Preferably, the first circularly polarized light has a wavelength of 350 nm to 600 nm, and the second circularly polarized light has a wavelength of 600 nm to 900 nm.

The cholesteric liquid crystal layer can selectively reflect only light of specific wavelengths; i.e., it is difficult to reflect all visible light. Specifically, the selective-reflection wavelength range $\Delta\lambda$ of the cholesteric liquid crystal layer is expressed by the following Equation 1:

<Equation 1>

$$\Delta\lambda = 2\lambda\ (ne - no) / (ne + no)$$

In Equation 1, "no" represents the refractive index, with respect to ordinary rays, of nematic liquid crystal molecules contained in the cholesteric liquid crystal layer; "ne" represents the refractive index, with respect to extraordinary rays, of the nematic liquid crystal molecules; and $\lambda$ represents the central wavelength of light selectively reflected (central selective-reflection wavelength).

As shown in Equation 1, the $\Delta\lambda$ (i.e.; selective-reflection wavelength range) depends on the molecular structure of each nematic liquid crystal *per se*. In this equation, when the value (ne - no) is increased, the selective-reflection wavelength range $\Delta\lambda$ increases. However, the value (ne - no) is generally 0.3 or less. When the value (ne - no) is greater

than 0.3, the nematic liquid crystals exhibit insufficient liquid crystal properties (e.g., alignment characteristics and liquid crystal transition temperature), resulting in that they are difficult to put into practice. Thus, practically, the selective-reflection wavelength range $\Delta\lambda$ of the cholesteric liquid crystal layer is up to about 150 nm. Generally, the $\Delta\lambda$ is preferably about 30 nm to 100 nm.

Meanwhile, the $\lambda$ (i.e.; central selective-reflection wavelength) of the cholesteric liquid crystal layer is expressed by the following Equation 2:

<Equation 2>

$$\lambda = (ne + no)\ P/2$$

In Equation 2, "ne" and "no" have the same meanings as defined in Equation 1; and "P" represents the length of a helical pitch (a single twist) of the cholesteric liquid crystal helix.

As shown in Equation 2, when the helical pitch of the cholesteric liquid crystal layer is constant, the $\lambda$ depends on the average refractive index and on the helical pitch length P of the cholesteric liquid crystal layer. Thus, in order to enhance selective reflectivity of the cholesteric liquid crystal layer, preferably, the cholesteric liquid crystal layers have different central selective-reflection wavelengths, and the helices in the cholesteric liquid crystal layers rotate to the same direction (i.e., to the right or left). The selective-reflection wavelength ranges of the cholesteric liquid crystal layers are preferably continuous. As used herein, the term "continuous" refers to that no distinct interval is present between two selective-reflection wavelength ranges neighboring each other, and the reflectance over these ranges is substantially 40% or more.

Thus, the distance between the $\lambda$s (i.e.; central selective-reflection wavelengths) of the cholesteric liquid crystal layers is preferably such that one selective-reflection wavelength range is continuous with at least another selective-reflection wavelength range.

The filter layer preferably has a reflectance of 40% or more with respect to light having a wavelength of $\lambda_0$ to $\lambda_0$/cos20° (wherein $\lambda_0$ represents the wavelength of irradiated light), which is incident at an angle of ±20°, wherein the angle of a vertically incident light is regarded as 0°. Particularly preferably, the filter layer has a reflectance of 40% or more with respect to light having a wavelength of $\lambda_0$ to $\lambda_0$/cos40° (wherein $\lambda_0$ represents the wavelength of irradiated light), which is incident at an angle of ±40°, wherein the angle of vertically incident light is regarded as 0°.

When the reflectance of the filter layer is 40% or more with respect to light of $\lambda_0$ to $\lambda_0$/cos20°, particularly $\lambda_0$ to $\lambda_0$/cos40° (wherein $\lambda_0$ represents the wavelength of irradiated light), it is made possible to eliminate problematic dependency of the reflectance on the angle at which light is irradiated. As a result, the filter layer can be applied to optical lens systems used in usual optical recording media.

Specifically, when there are laminated three cholesteric liquid crystal layers which have different central selective-reflection wavelengths and whose helices rotate to the same direction, the formed filter layer has a reflectivity as shown in FIG.4. As shown in FIG.4, the filter layer has a reflectance of 40% or more with respect to light incident perpendicularly to the filter (at an angle of 0°). In contrast, when light is incident from an oblique direction, the central selective-reflection wavelengths are gradually shifted to shorter wavelengths. For example, when light is incident into the liquid crystal layer at an oblique angle of 40°, the filter layer has a reflectivity as shown in FIG.5.

Similarly, when there are laminated two cholesteric liquid crystal layers which have different central selective-reflection wavelengths and whose helices rotate to the same direction, the formed filter layer having a reflectivity as shown in FIG.6. As shown in FIG.6, the filter layer has a reflectance of 40% or more with respect to light incident perpendicularly to the filter (at an angle of 0°). In contrast, when light is incident from an oblique direction, the central selective-reflection wavelength is gradually shifted on the shorter wavelength range. For example, when light is incident into the liquid crystal layer at an oblique angle of 20°, the filter layer has a reflectivity as shown in FIG. 7.

Notably, in a reflection range of $\lambda_0$ to 1.3$\lambda_0$ shown in FIG. 4, when $\lambda_0$ is 532 nm, 1.3$\lambda_0$ is 692 nm. Thus, a servo beam having a wavelength of 655 nm is undesirably reflected. This reflection range ($\lambda_0$ to 1.3$\lambda_0$) is suitable for light incident at an angle of ±40° into a filter used in an optical recording medium. However, when light incident at such a large angle is intended to be used, a servo operation can be carried out without any problems by masking a servo beam incident within an angle of ±20°. In addition, when the average refractive index of the cholesteric liquid crystal layers forming the filter layer is adjusted to be sufficiently large, light may all be incident into the filter within an incident angle of ±20°. In this case, only two cholesteric liquid crystal layers may be laminated so as to have a reflection range of $\lambda_0$ to 1.1$\lambda_0$ as shown in FIG. 6. Thus, transmission of the servo beam does not involve any difficulties.

As is clear from data shown in FIGs.4 to 7, the filter, for use in the present optical recording medium, reliably has a reflectance of 40% or more, even when light is incident thereinto at an angle of 0° to 20° (more preferably 0° to 40°). Thus, the filter does not cause any problems upon reading of signals.

The cholesteric liquid crystal layer is not particularly limited, so long as it has the above-described characteristics, and can be appropriately selected depending on the purpose. As mentioned above, the cholesteric liquid crystal layer contains a nematic liquid crystal compound and a chiral compound and, if necessary, further contains a polymerizable compound and other components.

- Nematic liquid crystal compound -

The nematic liquid crystal compounds are characterized in that a liquid crystal phase formed thereof solidifies at a temperature equal to or lower than their liquid crystal transition temperature. The nematic liquid crystal compound can be appropriately selected depending on the purpose from a liquid crystal compound, a polymer-liquid crystal compound and a polymerizable liquid crystal compound, all of which have a refractive index anisotropy Δn of 0.10 to 0.40. In use, the nematic liquid crystal compounds are heated so as to assume a liquid crystal state, and then aligned using, for example, an alignment substrate having undergone rubbing or a similar treatment. The obtained LC-aligned substrate is, for example, cooled as is for solidification.

The nematic liquid crystal compound is not particularly limited and can be appropriately selected depending on the purpose. Examples include the following compounds.

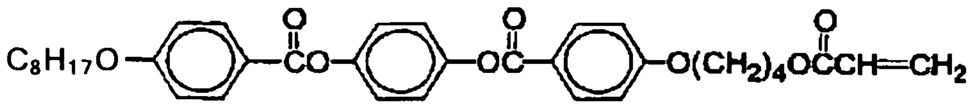

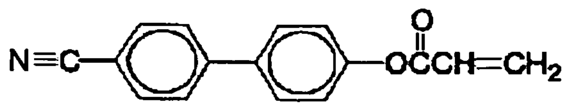

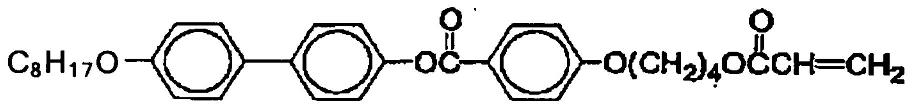

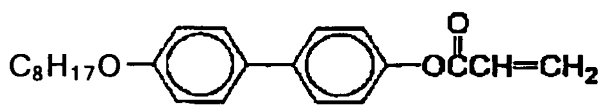

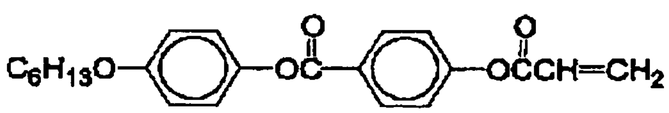

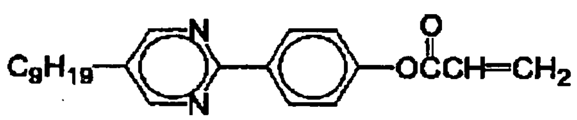

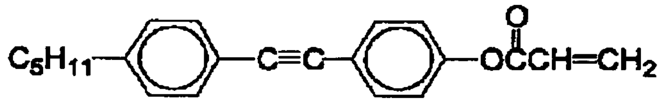

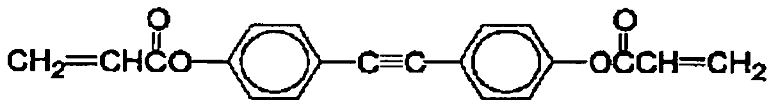

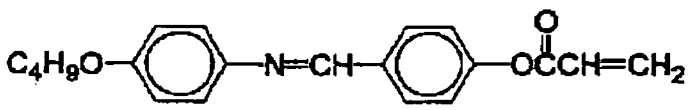

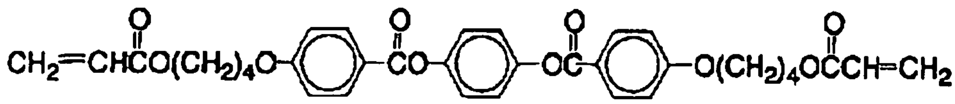

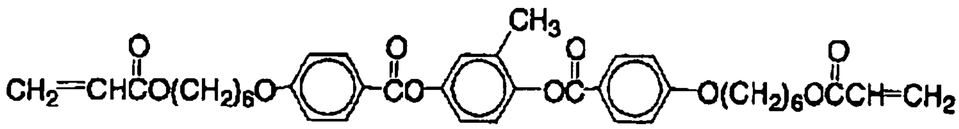

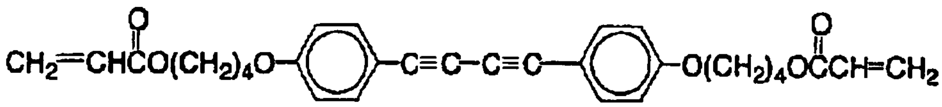

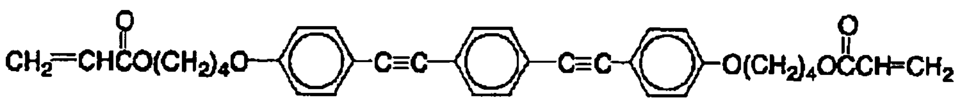

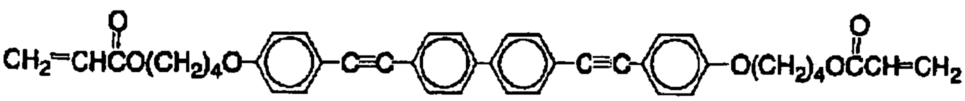

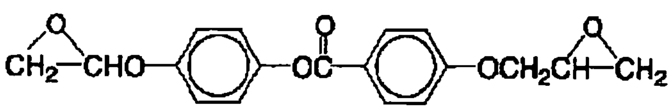

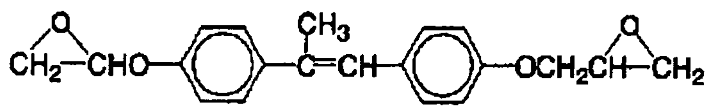

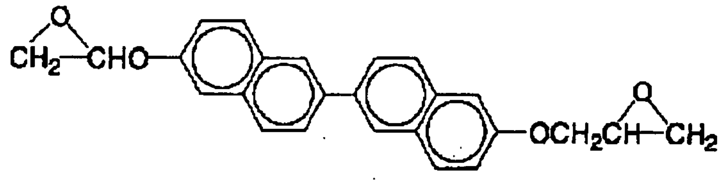

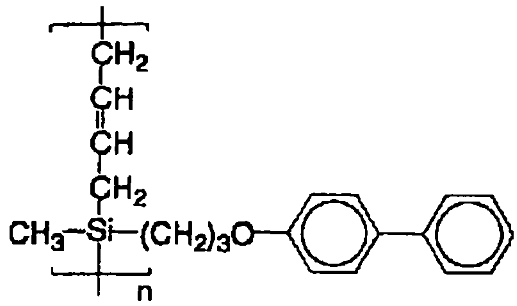

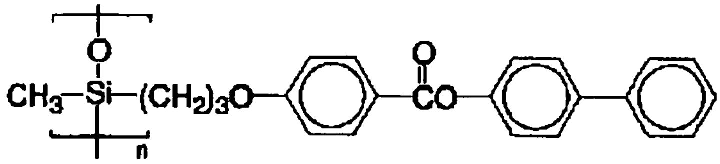

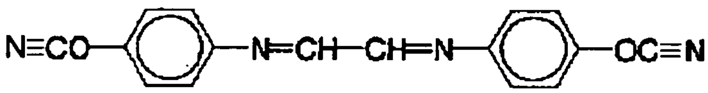

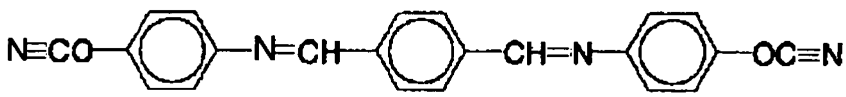

In the above formulas, n is an integer of 1 to 1,000. Notably, there are also preferably used compounds obtained by changing the side-chain-linking group contained in the above compounds to those listed below.

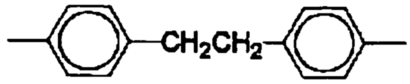

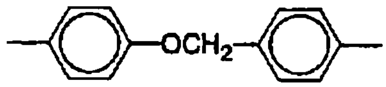

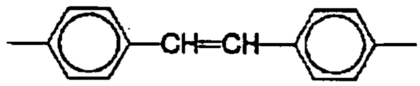

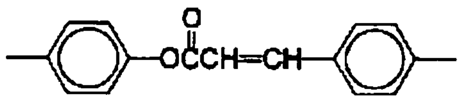

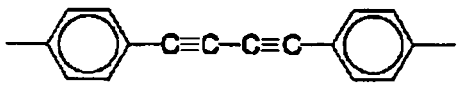

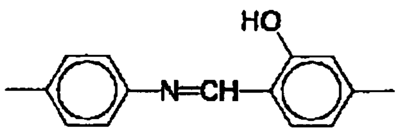

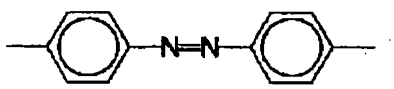

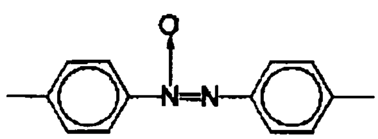

Among the above-listed nematic liquid crystal compounds, from the viewpoint of ensuring sufficient curing performance, those having a polymerizable group in the molecule thereof are preferred. In particular, ultraviolet (UV) polymerizable liquid crystal compounds are preferred. The UV polymerizable liquid crystal compounds may be commercially available one. Examples thereof include PALIOCOLOR LC242 (bland name, product of BASF Corp.); E7 (bland

name, product of Merck Ltd.); LC-Silicon-CC3767 (bland name, product of Wacker-Chem); and L35, L42, L55, L59, L63, L79 and L83 (bland name, product of Takasago International Corp.).

The nematic liquid crystal compound content is preferably 30% by mass to 99% by mass, more preferably 50% by mass to 99% by mass, based on the total solid content by mass of one cholesteric liquid crystal layer. When the content is less than 30% by mass, sufficient alignment of nematic liquid crystal compounds may not be attained.

- Chiral compound -

The chiral compound is not particularly limited and can be appropriately selected from known compounds depending on the purpose. From the viewpoint of imparting an improved hue or color purity to liquid crystal compounds, there maybe used isomannide compounds, catechine compounds, isosorbide compounds, fenchone compounds, carvone compounds and the following compounds listed below. These compounds may be used alone or in combination.

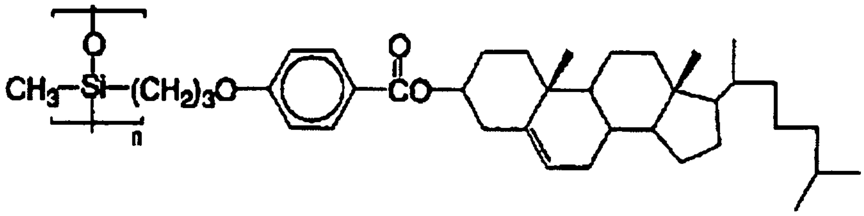

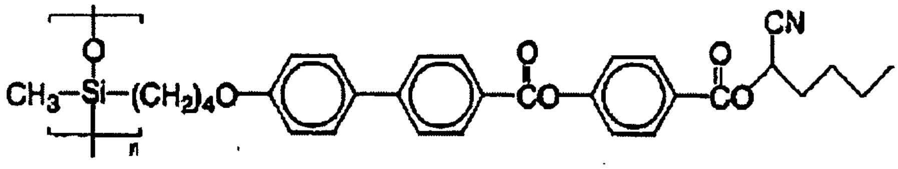

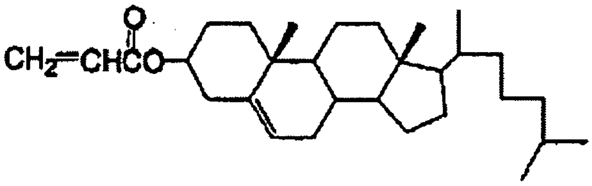

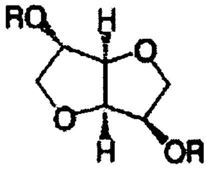

R = 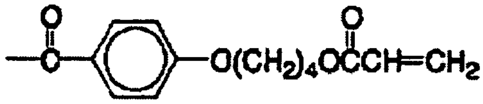

Left-hand twisted

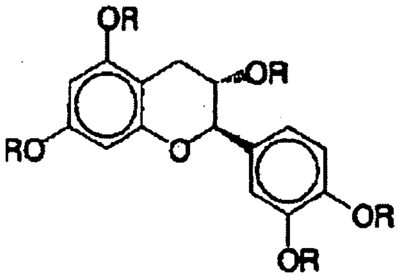

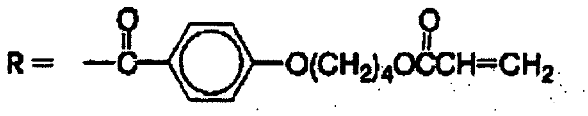

Left-hand twisted

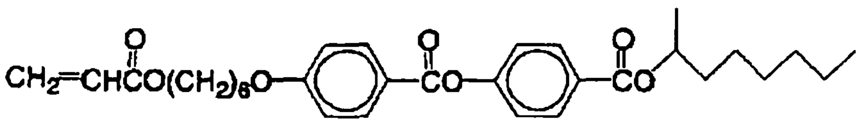

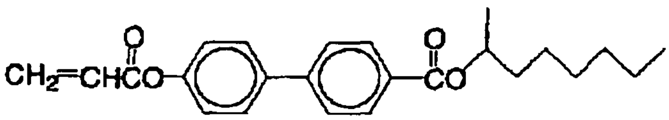

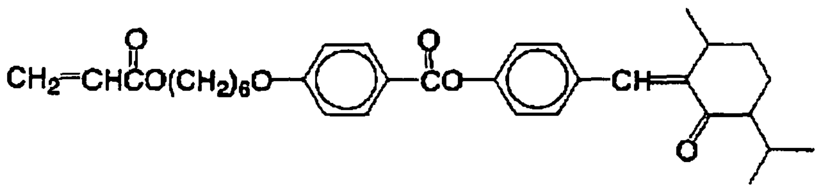

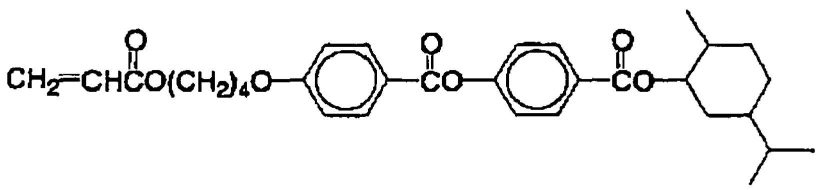

Also, commercially available chiral compounds may be used. Examples thereof include S101, R811 and CB15 (bland name, product of Merck Ltd.); and PALIOCOLOR LC756 (bland name, product of BASF Corp.).

The chiral compound content is preferably 0% by mass to 30% by mass, more preferably 0% by mass to 20% by mass, based on the total solid content by mass of one cholesteric liquid crystal layer. When the content is more than 30% by mass, sufficient alignment in the cholesteric liquid crystal layer may not be attained.

- Polymerizable compound -

A polymerizable compound may be incorporated into the cholesteric liquid crystal layer for the purpose of increasing the degree of curing (e.g., the degree of film strength). When the polymerizable compound is used in combination, the twisting power of liquid crystal compounds is changed (patterned) by light exposure (for example, selective

reflection wavelength distribution is formed), the formed helical structure (selective reflectivity) is fixed, and the strength of the fixed cholesteric liquid crystal layer is increased. Notably, in using a liquid crystal compound having a polymerizable group in the molecule thereof, the polymerizable compound is not necessarily added.

The polymerizable compound is not particularly limited and can be appropriately selected from known compounds depending on the purpose. Examples thereof include compounds (monomers) having an ethylenically unsaturated bond. Specific examples include polyfunctional monomers such as pentaerythritol tetraacrylate and dipentaerythritol hexaacrylate.

Specific examples of the monomer having an ethylenically unsaturated bond include those listed below. These monomers may be used alone or in combination.

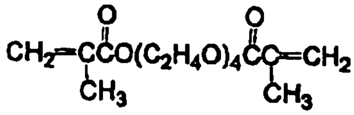

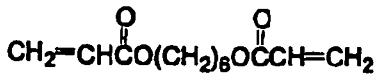

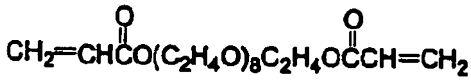

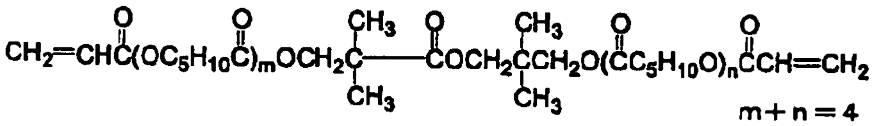

m+n=4

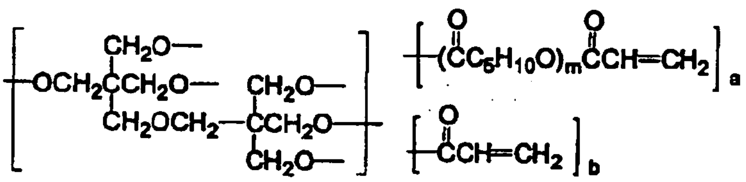

A : m=1, a=6, b=0
B : m=2, a=6, b=0

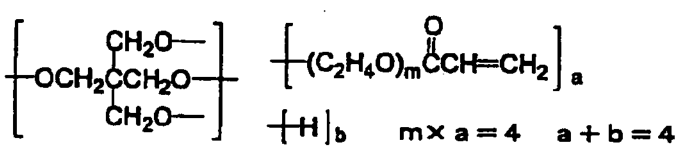

m×a=4 a+b=4

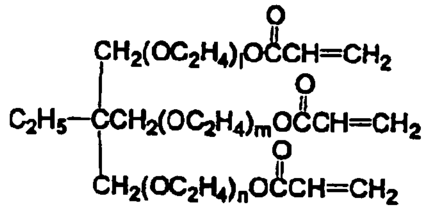

l + m + n = 3. 5

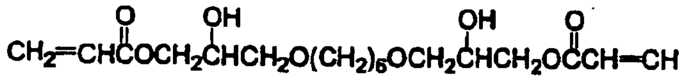

The polymerizable compound content is preferably 0% by mass to 50% by mass, more preferably 1% by mass to 20% by mass, based on the total solid content by mass of one cholesteric liquid crystal layer. When the content is more than 50% by mass, alignment in the cholesteric liquid crystal layer may be adversely affected.

- Other components -

The other components are not particularly limited and can be appropriately selected depending on the purpose. Examples thereof include photopolymerization initiators, sensitizers, binder resins, polymerization inhibitors, solvents, surfactants, thickeners, dyes, pigments, ultraviolet absorbers and gelling agents.
The photopolymerization initiator is not particularly limited and can be appropriately selected from known initiators depending on the purpose. Examples thereof include p-methoxyphenyl-2,4-bis(trichloromethyl)-s-triazine, 2-(p-butoxystyryl)-5-trichloromethyl-1,3,4-oxadiazole, 9-phenylacridine, 9,10-dimethylbenzophenazine, benzophenone/Michler's ketone, hexaarylbiimidazole/mercaptobenzimidazole, benzyldimethylketal, and thioxanthone/amine. These may be used alone or in combination.
In addition, the photopolymerization initiator may be commercially available one, and examples thereof include IRGACURE 907, IRGACURE 369, IRGACURE 784 and IRGACURE 814 (bland name, product of Chiba Specialty Chemicals KK); and Lucirin TPO (bland name, product of BASF Corp.).
The photopolymerization initiator content is preferably 0.1% by mass to 20% by mass, more preferably 0.5% by mass to 5% by mass, based on the total solid content by mass of one cholesteric liquid crystal layer. When the content is less than 0.1% by mass, a time-consuming light-exposing process is required due to low curing efficiency, whereas when the content is more than 20% by mass, the optical transmittance may be deteriorated in a range from the ultraviolet region to the visible region.
The sensitizer is optionally incorporated into the cholesteric liquid crystal layer for the purpose of increasing its curing performance. The sensitizer is not particularly limited and can be appropriately selected known sensitizers depending on the purpose. Examples thereof include diethyl thioxanthone and isopropyl thioxanthone.
The sensitizer content is preferably 0.001% by mass to 1.0% by mass based on the total solid content by mass of one cholesteric liquid crystal layer.
The binder resin is not particularly limited and can be appropriately selected known resins depending on the purpose. Examples thereof include polystyrene compounds (e.g., polyvinyl alcohol, polystyrene and poly-$\alpha$-methylstyrene); cellulose resins (e.g., methyl cellulose, ethyl cellulose and acetyl cellulose); acidic cellulose derivatives having a carboxyl group-containing side chain; acetal resins (e.g., polyvinyl formal and polyvinyl butyral); methacrylic acid copolymers, acrylic acid copolymers, itaconic acid copolymers, crotonic acid copolymers, maleic acid copolymers and partially esterified maleic acid copolymers; alkyl acrylate homopolymers and alkyl methacrylate homopolymers; and hydroxyl group-containing polymers. These resins may be used alone or in combination.
Examples of the alkyl group contained in the alkyl acrylate homopolymers or alkyl methacrylate homopolymers include methyl, ethyl, n-propyl, n-butyl, iso-butyl, n-hexyl, cyclohexyl and 2-ethylhexyl.
Examples of the hydroxyl group-containing polymer include benzyl (meth)acrylate/(methacrylic acid homopolymer) acrylic acid copolymers and multipolymers of benzyl (meth)acrylate/(meth)acrylic acid/other monomers.
The binder resin content is preferably 0% by mass to 80% by mass, more preferably 0% by mass to 50% by mass, based on the total solid content by mass of one cholesteric liquid crystal layer. When the content is more than 80% by mass, sufficient alignment in the cholesteric liquid crystal layer may not be attained.
The polymerization inhibitor is not particularly limited and can be appropriately selected depending on the

purpose. Examples thereof include hydroquinone, hydroquinone monomethyl ethers, phenothiazine, benzoquinone and derivatives thereof.

The polymerization inhibitor content is preferably 0% by mass to 10% by mass, more preferably 100 ppm to 1% by mass, based on the total solid content by mass of one cholesteric liquid crystal layer.

The solvent is not particularly limited and can be appropriately selected from know solvents depending on the purpose. Examples thereof include alkoxypropionate esters (e.g., methyl 3-methoxypropionate, ethyl 3-methoxypropionate, propyl 3-methoxypropionate, methyl 3-ethoxypropionate, ethyl 3-ethoxypropionate and propyl 3-ethoxypropionate); esters of alkoxy alcohols (e.g., 2-methoxypropylacetate, 2-ethoxypropylacetate and 3-methoxybutylacetate); lactate esters (e.g., methyl lactate and ethyl lactate); ketones (e.g., methyl ethyl ketone, cyclohexanone and methylcyclohexanone), γ-butyrolactone, N-methylpyrrolidone; dimethylsulfoxide, chloroform and tetrahydrofuran. These solvents may be used alone or in combination.

<Other layers>

The other layers are not particularly limited and can be appropriately selected depending on the purpose. Examples thereof include a first gap layer and a second gap layer.

- First gap layer -

The first gap layer is optionally provided between the selective reflection layer and the reflective film for the purpose of smoothing a surface of a second substrate. Moreover, the first gap layer is effective for adjusting the size of a hologram formed in the recording layer. Specifically, a region where an information beam and a reference beam interfere with each other is required to be adjusted so as to have an appropriate size in the recording layer, and therefore, provision of a gap is advantageous between the recording layer and the servo pit pattern.

The first gap layer may be formed by, for example, coating UV curable resin or the like on the servo pit pattern by spin coating or a similar technique, and by curing the coated resin. Alternatively, when a filter layer is formed using a transparent base, the transparent base also serves as the first gap layer.

The thickness of the first gap layer is not particularly limited and can be appropriately selected depending on the purpose. Preferably, the thickness is 1 μm to 100 μm.

- Second gap layer -

The second gap layer is provided between the recording layer (photodegradable recording layer) and the selective reflection layer in accordance with needs. This layer is formed for preventing deterioration in multiplex recording performance which is caused by overconsumption of monomers that is occurrs when light is excessively applied to photopolymers present in a point at which information and reference beams focus.

The material for forming the second gap layer is not particularly limited and can be appropriately selected depending on the purpose. Examples thereof include transparent resin films formed by, for example, triacetyl cellulose (TAC), polycarbonate (PC), polyethylene terephthalate (PET), polystyrene (PS), polysulfone (PSF), polyvinyl alcohol (PVA) and polymethyl methacrylate (PMMA); and norbornene resin films such as the ARTON film (bland name, product of JSR Corp.) and the ZEONOA (bland name) film (product of Nippon Zeon). Among these films, those having high isotropy are preferred, with a TAC film, a PC film, the ARTON film (bland name) and the ZEONOA (bland name) film being particularly preferred.

The thickness of the second gap layer is not particularly limited and can be appropriately selected depending on the purpose. Preferably, the thickness is 1 μm to 200 μm.

Referring now to the drawings, the optical recording medium of the present invention will be described in more detail.

FIG. 3 is a schematic cross-sectional view of the structure of an optical recording medium in an embodiment of the present invention. The optical recording medium 21 of this embodiment includes a first substrate 1 made of a polycarbonate resin, a servo pit pattern 3 formed in the first substrate 1, and a reflective film 2 formed on the servo pit pattern 3 by coating Al, Au, Pt or the like. In the optical recording medium shown in FIG.3, although the servo pit pattern 3 is formed in the entire surface of the first substrate 1, the pattern may be formed periodically. The height of each servo pit of the pattern is up to 1,750 angstroms (175 nm), which is much smaller than the thickness of the first substrate or the other layers.

The surface of the first substrate having no servo pits is provided with the dichroic mirror layer serving as a selective reflection layer 6, which is formed by multiple vapor deposition of Ag.

A recording layer 4 is formed on the reflective film 2. The optical recording medium 21 includes the selective reflection film 6 and the recording layer 4 which are sandwiched between the first substrate 1 and the second substrate

5 (polycarbonate resin-substrate).

The optical recording medium 21 of this embodiment may have a shape of disc or card. In the optical recording medium 21, the first substrate 1, the selective reflection layer 6, the recording layer 4 and the second substrate 5 are in thickness 0.6 mm, 2 μm to 3 μm, 0.6 μm and 0.6 mm, respectively, with the total thickness being about 1.3 mm.

With reference to FIG.8, next will be described optical operations carried out around the optical recording medium 21. Firstly, a beam (red light) is emitted from a servo laser, and almost 100% of the beam is reflected on a dichroic mirror 13 and then passed through an objective lens 12. The beam for servo is adjusted by the objective lens 12 so as to be focused on the reflective film 2 of the optical recording medium 21. The dichroic mirror 13 allows transmission of green or blue light, and reflects almost 100% of red light. The beam for servo is incident from a light-enter/emission surface A of the optical recording medium 21 and passes through the second substrate 5, the recording layer 4 and the selective reflection layer 6. The beam is reflected on the reflective film 2. The reflected beam passes again through the selective reflection layer 6, the recording layer 4 and the second substrate 5, and emitted from the light-enter/emission surface A. The thus-returned beam passes through the objective lens 12, and almost 100% thereof is reflected on the dichroic mirror 13. The reflected beam is detected in servo information by a servo information detector (not illustrated). The detected servo information is used for a focus servo operation, a tracking servo operation, a slide servo operation, etc. Since the hologram material forming the recording layer 4 is not sensitive to red light, even when the servo beam passes through the recording layer 4 or is diffusively reflected on the reflective film 2, the recording layer 4 is not adversely affected. In addition, since almost 100% of the returned servo beam, which has reflected on the reflective film 2, is reflected on the dichroic mirror 13, the servo beam is not detected by a CMOS sensor or a CCD 14 used for detecting a reproduced image, and thus does not become noise with respect to a reproduction beam.

Separately, an information beam and a reference beam for recording are generated by a recording/reproducing laser. These beams are linearly polarized after passing through a polarizing plate 16. The linearly polarized beams circularly polarized after passing through a half mirror 17 and a quarter wave plate 15. The circularly polarized beams pass through the dichroic mirror 13. Thereafter, these beams are adjusted by the objective lens 11 so that the information beam and the reference beam for recording form an interference pattern in the recording layer 4 of the optical recording medium 21. Specifically, the information beam and the reference beam for recording are incident from the light-enter/emission surface A and interfere with each other in the recording medium 4 to thereby form an interference pattern therein. Subsequently, these beams enter into the selective reflection layer 6 under the recording layer 4, and returned by reflection at a position above the bottom surface of the selective reflection layer 6. In other words, the information beam and the reference beam for recording do not reach the reflective film 2. This is because the selective reflection layer 6 has a property to allow transmission of only red light.

(Method for manufacturing optical recording medium)

A method for manufacturing an optical recording medium of the present invention includes at least a recording layer-forming step and a heating step and, if necessary, further includes other steps.

The recording layer-forming step is a step of forming a recording layer from the photosensitive composition of the present invention. In this step, the recording layer is formed by, for example, coating the present photosensitive composition on a selective reflection layer and drying the coated composition.

The heating step is a step of heating at 30°C for 30 min or longer the entirety of an optical recording medium in which the recording layer has been formed.

The other steps are, for example, a reflective layer-forming step, a selective reflection layer-forming step and a protective layer-forming step.

(Optical recording and reproducing methods)

An optical recording method of the present invention includes applying an information beam and a reference beam to the present optical recording medium so that the optical axis of the information beam is coaxial with that of the reference beam; and recording information in a recording layer in the form of interference pattern formed by interference of the information and reference beams.

An optical reproducing method in the present invention includes reproducing information by applying a reference beam to the interference pattern recorded in the recording layer by the present optical recording method.

In this case, preferably, recorded information is reproduced by applying a reference beam to the interference pattern at the same angle as the reference beam used during recording in the optical recording medium.

As described above, according to the optical recording and reproducing methods, information is recorded by superposing, inside a photosensitive recording layer, the information beam having a two-dimensional intensity distribution and the reference beam having an intensity almost equal to that of the information beam, and by forming an optical characteristic distribution inside the recording layer using the formed interference pattern. Meanwhile, written information

is read (reproduced) by applying only a reference beam to the recording layer in the same arrangement as employed in recording to emit, from the recording layer, a reproduction beam having an intensity distribution corresponding to the optical characteristic distribution formed inside the recording layer.

The optical recording and reproducing methods of the present invention is carried out by using an optical recording apparatus of the present invention described below.

(Optical recording apparatus)

With reference to FIG.9, next will be described an optical recording apparatus (optical recording and reproducing apparatus) used in the present optical recording and reproducing methods.

FIG.9 shows the entire configuration of an optical recording apparatus of an embodiment of the present invention. This apparatus includes an optical recording apparatus and an optical reproducing apparatus.

The optical recording apparatus 100 includes a spindle 81 to which an optical recording medium 20 is mounted, a spindle motor 82 for rotating the spindle 81, and a spindle servo circuit 83 for controlling the spindle motor 82 so that the rotation speed of the optical recording medium 20 is maintained at a predetermined level. In addition, the optical recording apparatus 100 further includes a pickup 31 and a drive device 84. The pickup 31 is used for recording information by applying an information beam and a reference beam to the optical recording medium 20; and for reproducing information recorded in the optical recording medium 20 by applying a reference beam for reproduction to the optical recording medium 20 and by detecting a reproduction beam. The drive device 84 enables the pickup 31 to move in the radial direction of the optical recording medium 20.

The optical recording and reproducing apparatus 100 further includes a detection circuit 85, a focus servo circuit 86, a tracking servo circuit 87 and a slide servo circuit 88. The detection circuit 85 is for detecting a focus error signal FE, a tracking error signal TE and a reproduction signal RF from signals output from the pickup 31. The focus servo circuit 86 carries out a focus servo operation by driving an actuator provided inside the pickup 31, on the basis of the focus error signal FE detected by the detection circuit 85, so as to move an objective lens (not shown) in the thickness direction of the optical recording medium 20. The tracking servo circuit 87 carries out a tracking servo operation by driving an actuator provided inside the pickup 31, on the basis of the tracking error signal TE detected by the detection circuit 85, so as to move the objective lens in the radial direction of the optical recording medium 20. The slide servo circuit 88 carries out a slide servo operation by controlling the drive device 84, on the basis of a tracking error signal TE and commands from a controller (described below), so as to move the pickup 31 in the radial direction of the optical recording medium 20.

The optical recording and reproducing apparatus 100 further includes a signal processing circuit 89, a controller 90 and an operation unit 91. The signal processing circuit 89 decodes data output from a CMOS or a CCD array (described below) in the pickup 31 so as to reproduce data recorded in a data area of the optical recording medium 20. In addition, this circuit creates a reference clock on the basis of a reproduction signal RF detected by the detection circuit 85; and distinguishes individual addresses. The controller 90 controls the overall optical recording and reproducing apparatus 100. The operation unit 91 gives a variety of commands to the controller 90. The controller 90, furthermore, receives the reference clock and address information output from the signal processing circuit 89, and controls, for example, the pickup 31, the spindle servo circuit 83 and the slide servo circuit 88. The spindle servo circuit 83 receives the reference clock output from the signal processing circuit 89. The controller 90 includes a CPU (central processing unit), a ROM (read only memory) and a RAM (random access memory), and the CPU realizes the function of the controller 90 by executing programs stored in the ROM on the RAM (serving as a working area).

The optical recording and reproducing apparatus used in the present optical recording and reproducing methods uses the present optical recording medium, and thus, provides the desired S/N ratio even when light exposure is carried out at a dose required for attaining high signal intensity. This apparatus, therefore, ensures sufficient signal intensity and sufficient S/N ratio at the same time, and thus, realizes high-density recording which has not yet been attained.

Examples

The present invention will next be described in detail by way of examples, which should not be construed as limiting the present invention thereto.

(Example 1)

- Manufacture of optical recording medium -

An optical recording medium is manufactured by laminating, in sequence, a first substrate, a reflective layer, an adhesive layer, a selective reflection layer, a protective layer (a second gap layer), a recording layer and a second

substrate.

-- Production of second substrate --

The second substrate was produced from a polycarbonate resin so as to have a diameter, inner diameter and thickness of 120 mm, 15 mm and 0.6 mm, respectively.

-- Production of first substrate --

The first substrate used was a polycarbonate resin-substrate having a diameter, inner diameter and thickness of 120 mm, 15 mm and 0.6 mm, respectively, which is generally used for DVD+RW. This substrate has a surface with a servo pit pattern having a track pitch, pit depth and pit width of 0.74 μm, 140 nm and 300 nm, respectively.

The reflective layer was formed on the surface of the servo pit pattern of the first substrate. Specifically, the reflective layer was formed from Ag by DC magnetron sputtering so as to attain a thickness of 150 nm. Thereafter, the thus-obtained Ag reflective layer was provided with the adhesive layer (a first gap layer) (thickness: 20 μm) by spin coating of an adhesive (SD640, product of Dainippon Ink and Chemicals, Incorporated) onto the reflective layer.

-- Production of selective reflection layer --

Firstly, 30 Ag films were stacked on a polycarbonate film (thickness: 100 μm) (bland name: UPIRON; product of MITSUBISHI GAS CHEMICAL CO., INC.) by vapor deposition (DC magnetron sputtering), to thereby form a dichroic mirror layer having a thickness of 3 μm. Subsequently, the thus-obtained dichroic mirror layer was punched out so as to have the same disc-shape as the first substrate to be laminated by the layer.

<Preparation of coating liquid for forming recording layer (recording-layer coating liquid)>

A recording-layer coating liquid was prepared at 25°C and 50%relative humidity from the following components.

- Composition of recording-layer coating liquid -

- 1-(3-Naphth-1-ylthio)propylthio)naphthalene: 0.1825 g
- IRGACURE 784 (product of Chiba Specialty Chemicals KK): 0.02 g
- Epolite 100E (product of KYOEISHA CHEMICAL Co., LTD., average epoxy equivalent: 155 g/eq., containing ethylene oxide moiety): 1.1966 g
- Pentaerythritol tetrakis(3-mercaptopropionate): 1.0019 g
- Tris-2,4,6-(dimethylaminomethyl)phenol: 0.1358 g

-- Fabrication of optical recording medium --

The above-obtained selective reflection layer was bonded onto the first substrate having the reflective layer and the adhesive layer (first gap layer). Specifically, bonding of the selective reflection layer was carried out such that the base film surface thereof faced the servo pit pattern and that no air bubbles existed between the layer and the substrate. Through the above procedure, the selective reflection layer was provided on the first substrate.

Thereafter, a UV-curable resin (SD640, product of Dainippon Ink and Chemicals, Incorporated) was coated on the filter layer by spin coating so as to attain a thickness of 20 μm, to thereby form the protective layer (second gap layer). The thus-laminated first substrate and the second substrate were held 500 μm apart in parallel by a jig such that the laminated surface of the first substrate faced the second substrate. The above-prepared recording layer-coating liquid was injected between these substrates by a dispenser (product of MUSASHI ENGINEARING, INC., ML-5000X), followed by being left to stand at 30°C for 30 min while maintaining the distance therebetween. The photosensitive composition spontaneously cured. Through the above procedure, an optical recording medium of Example 1 was manufactured.

(Example 2)

- Manufacture of optical recording medium -

The procedure of Example 1 was repeated, except that the recording layer-coating liquid was changed to a recording layer-coating liquid having the following composition, to thereby manufacture an optical recording medium of Example 2.

<Preparation of recording-layer coating liquid>

A recording-layer coating liquid was prepared at 25°C and 50%relative humidity from the following components.

- Composition of recording-layer coating liquid -

- 1-(3-Naphth-1-ylthio)propylthio)naphthalene: 0.1825 g
- IRGACURE 784 (product of Chiba Specialty Chemicals KK): 0.02 g
- Epolite 100E (product of KYOEISHA CHEMICAL Co., LTD., average epoxy equivalent: 155 g/eq., containing ethylene oxide moiety): 0.8327 g
- Epolite 200P (product of KYOEISHA CHEMICAL Co., LTD., average epoxy equivalent: 200 g/eq., containing no ethylene oxide moiety): 0.5000 g
- Pentaerythritol tetrakis(3-mercaptopropionate): 1.0019 g
- Tris-2,4,6-(dimethylaminomethyl)phenol: 0.1358 g

(Comparative Example 1)

- Manufacture of optical recording medium -

The procedure of Example 1 was repeated, except that the recording layer-coating liquid was changed to a recording layer-coating liquid having the following composition, to thereby manufacture an optical recording medium of Comparative Example 1.

<Preparation of recording-layer coating liquid>

A recording-layer coating liquid was prepared at 25°C and 50%relative humidity from the following components.

- Composition of recording-layer coating liquid -

- 1-(3-Naphth-1-ylthio)propylthio)naphthalene: 0.1825 g
- IRGACURE 784 (product of Chiba Specialty Chemicals KK): 0.02 g • Epolite 400E (product of KYOEISHA CHEMICAL Co., LTD., average epoxy equivalent: 270 g/eq., containing ethylene oxide moiety): 1.2007 g
- Pentaerythritol tetrakis(3-mercaptopropionate): 0.7524 g
- Tris-2,4,6-(dimethylaminomethyl)phenol: 0.1358 g

(Example 3)

- Manufacture of optical recording medium -

The procedure of Example 1 was repeated, except that the recording layer-coating liquid was changed to a recording layer-coating liquid having the following composition, to thereby manufacture an optical recording medium of Example 3.

<Preparation of recording-layer coating liquid>

A recording-layer coating liquid was prepared at 25°C and 50%relative humidity from the following components.

- Composition of recording-layer coating liquid -

- 1-(3-Naphth-1-ylthio)propylthio)naphthalene: 0.1825 g
- IRGACURE 784 (product of Chiba Specialty Chemicals KK): 0.02 g
- Epolite 200P (product of KYOEISHA CHEMICAL Co., LTD., average epoxy equivalent: 200 g/eq., containing no ethylene oxide moiety): 1.3662 g
- Pentaerythritol tetrakis(3-mercaptopropionate): 0.8325 g
- Tris-2,4,6-(dimethylaminomethyl)phenol: 0.1358 g

(Comparative Example 2)

- Manufacture of optical recording medium -

The procedure of Example 1 was repeated, except that the recording layer-coating liquid was changed to a recording layer-coating liquid having the following composition, to thereby manufacture an optical recording medium of Comparative Example 2.

<Preparation of recording-layer coating liquid>

A coating liquid for forming a holographic recording layer was prepared at 25°C and 50%relative humidity from the following components in tanks A and B.

- Composition of recording-layer coating liquid -

[Tank A]:

- Biuret trimer of hexamethylene diisocyanate: 292.0 g
- Hexamethylene diisocyanate: 97.4 g
- Tribromophenyl acrylate: 64.22 g
- IRGACURE 784 (product of Chiba Specialty Chemicals KK): 14 g
- 3,5-Ditertialybutyl-4-hydroxytoluene: 210 mg

[Tank B]:

- PolyFox™T (Omnova Solutions, Inc.): 817.9 g
- Polypropyleneoxide triol (average molecular weight: 1,000): 517.9 g
- Tertialybutyl peroxide: 580 μL
- Tin dibutyllaurate: 10.2 g

(Example 4)

- Manufacture of optical recording medium -

The procedure of Example 1 was repeated, except that a recording layer-coating liquid was prepared at 25°C and 80%relative humidity instead of at 25°C and 50%relative humidity, to thereby manufacture an optical recording medium of Example 4.

Each of the recording layer-coating liquids (photosensitive compositions) of Examples 1 to 4 and Comparative Examples 1 and 2 was analyzed for the following various properties. The results are shown in Table 1.

<Whether or not mixture of component (B) epoxy compound and component (C) thiol group-containing compound turns into a gel within 30 min after heating to 30°C (gelling time)>

While maintained at 30°C by a heater, a mixture of the component (B) epoxy compound and the component (C) thiol group-containing compound was measured for viscosity by a Visco Tester VT550 (product of EKO INSTRUMENTS CO., LTD., rheometer). A viscosity of 107 mPa • s was defined as a gelling point of the mixture, and a gelling time required for reaching the gelling point was measured.

<Whether or not mixture of component (B) epoxy compound and component (C) thiol group-containing compound spontaneously exhibits an exothermic peak within 30 min after mixing>

A small amount of a mixture of the component (B) epoxy compound and the component (C) thiol group-containing compound was placed in an aluminum pan, and then the mixture was analyzed by a thermogravimetry-differential thermal analyzer (product of Seiko Instruments Inc., EXSTAR6000TG/DTA) for calorific value and a period of time required for reaching an exothermic peak.

<Water content>

Each of the recording layer-coating liquids (photosensitive compositions) of Examples 1 to 4 and Comparative Examples 1 and 2 was analyzed by the Karl Fischer's method for water content (% by mass).

Table 1

| | Gelling time (min) | Conditions of photosensitive layer | Exothermic peak (min) | Water content (% by mass) |
|---|---|---|---|---|
| Ex. 1 | 10 | Good | 8 | 1.2 |
| Ex. 2 | 15 | Good | 12 | 0.4 |
| Comp. Ex. 1 | 540 | Good | Not observed | 0.3 |
| Ex. 3 | 18 | Good | 32 | 0.9 |
| Comp. Ex. 2 | 4 | Voids generated | 1 | 0.0 |
| Ex. 4 | 39 | Some portion uncured (peripheral portion uncured) | 25 | 2.7 |

<Recording in recording layer>

Each of the above-obtained optical recording media was analyzed by a co-linear optical recording and reproducing tester (product of Pulstec Industrial Co., SHOT-1000). Specifically, the optical recording medium was written and read for measuring exposure dose required for recording, an S/N ratio in recording at the exposure dose, and the number of times of possible multiplex recording when spirally multiplex-recorded (7 x 7). In addition, coloring of a recording area was evaluated according to the following ratings. The results are shown in Table 2.

- Coloring of recording area -

A: No coloring observed
B: Coloring observed, but signals readable
C: Coloring observed, and signals not readable

Table 2

| | S/N | Possible multiplex recording (times) | Coloring of recording area |
|---|---|---|---|
| Ex. 1 | 5.6 | >49 | A |

(continued)

| | S/N | Possible multiplex recording (times) | Coloring of recording area |
|---|---|---|---|
| Ex. 2 | 5.2 | >49 | A |
| Comp. Ex. 1 | 4.8 | >49 | A |
| Ex. 3 | 2.4 | 30 | B |
| Comp. Ex. 2 | - | - | - |
| Ex. 4 | 4.9 | 45 | A |
| * Optical recording medium of Comp. Ex. 2 was not recordable and reproducible | | | |

Industrial Applicability

The photosensitive composition of the present invention is stable at high humidity, allows easy handling over time in a liquid state, and can be applied to various molding methods. The optical recording medium having a recording layer formed of the photosensitive composition achieves sufficient signal intensity and desired S/N ratio. Thus, the optical recording medium can be applied widely to various hologram optical recording media attaining high-sensitive multiplex recording.

## Claims

**1.** A photosensitive composition comprising:

(A) a photoreactive material,
(B) an epoxy compound having an average epoxy equivalent of 230 g/eq. or less and having two or more epoxy groups in the molecule thereof, and
(C) a thiol group-containing compound,

wherein the photosensitive composition is used for forming a recording layer which records information using holography.

**2.** The photosensitive composition according to claim 1, wherein (B) the epoxy compound reacts with (C) the thiol group-containing compound to form a polymerized product.

**3.** The photosensitive composition according to any one of claims 1 and 2,
wherein a mixture of (B) the epoxy compound and (C) the thiol group-containing compound turns into a gel within 30 min after heating to 30°C.

**4.** The photosensitive composition according to any one of claims 1 to 3, wherein a mixture of (B) the epoxy compound and (C) the thiol group-containing compound spontaneously exhibits an exothermic peak within 30 min after mixing.

**5.** The photosensitive composition according to any one of claims 1 to 4, wherein (B) the epoxy compound contains an ethylene oxide moiety.

**6.** The photosensitive composition according to any one of claims 1 to 5, wherein (C) the thiol group-containing compound is a mercaptan compound.

**7.** The photosensitive composition according to any one of claims 1 to 6, wherein (A) the photoreactive material contains a polymerizable compound and a polymerization initiator.

**8.** The photosensitive composition according to claim 7, wherein the polymerizable compound is at least one compound selected from radical polymerizable compounds.

**9.** The photosensitive composition according to any one of claims 1 to 8, further comprising a curing promoter which is at least one of a tertialy alkylamine, a tertialy aromatic amine and a tertialy alicyclic amine.

**10.** The photosensitive composition according to any one of claims 1 to 9, wherein the photosensitive composition has a water content as measured by the Karl Fischer's method of 0.01% by mass to 2.5% by mass.

**11.** An optical recording medium comprising:

a recording layer which is formed of the photosensitive composition according to any one of claims 1 to 10 and which records information using holography.

**12.** The optical recording medium according to claim 11, wherein the optical recording medium comprises, in sequence, a first substrate, a selective reflection layer, a recording layer and a second substrate.

**13.** The optical recording medium according to claim 12, wherein the selective reflection layer allows transmission of a first light and reflects a second light.

**14.** A method for manufacturing an optical recording medium comprising:

forming a recording layer using the photosensitive composition according to any one of claims 1 to 10, and heating at 30°C for 30 min or longer the entirety of an optical recording medium in which the recording layer has been formed.

**15.** An optical recording method comprising:

applying an information beam and a reference beam to the optical recording medium according to any one of claims 11 to 13 so that the optical axis of the information of beam is coaxial with that of the reference beam, and recording information in a recording layer in the form of interference pattern formed by interference of the information beam and the reference beam.

**16.** An optical recording apparatus comprising:

a light-irradiating unit which applies a coherent information beam and a coherent reference beam to the optical recording medium according to any one of claims 11 to 13 so that the optical axis of the information beam is coaxial with that of the reference beam, and
an interference pattern-recording unit which forms an interference pattern by interference of the information beam and the reference beam and which records the interference pattern in the optical recording medium.

FIG. 1

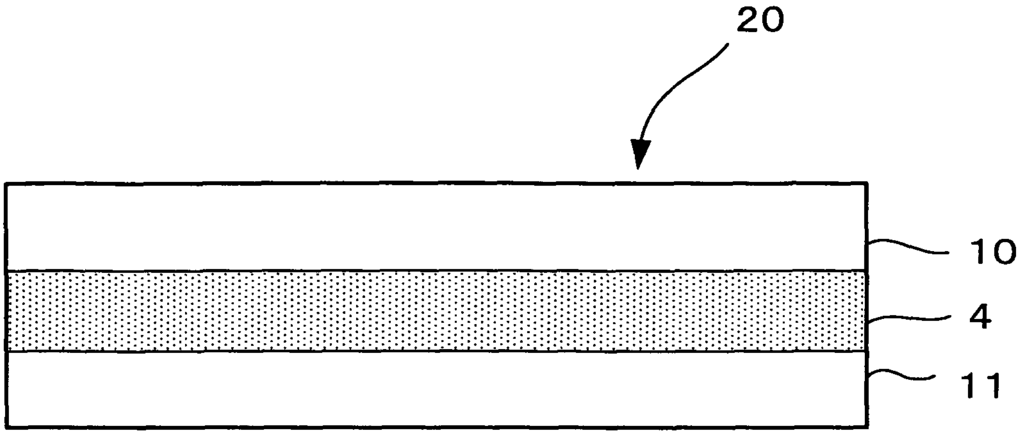
20
10
4
11

FIG. 2

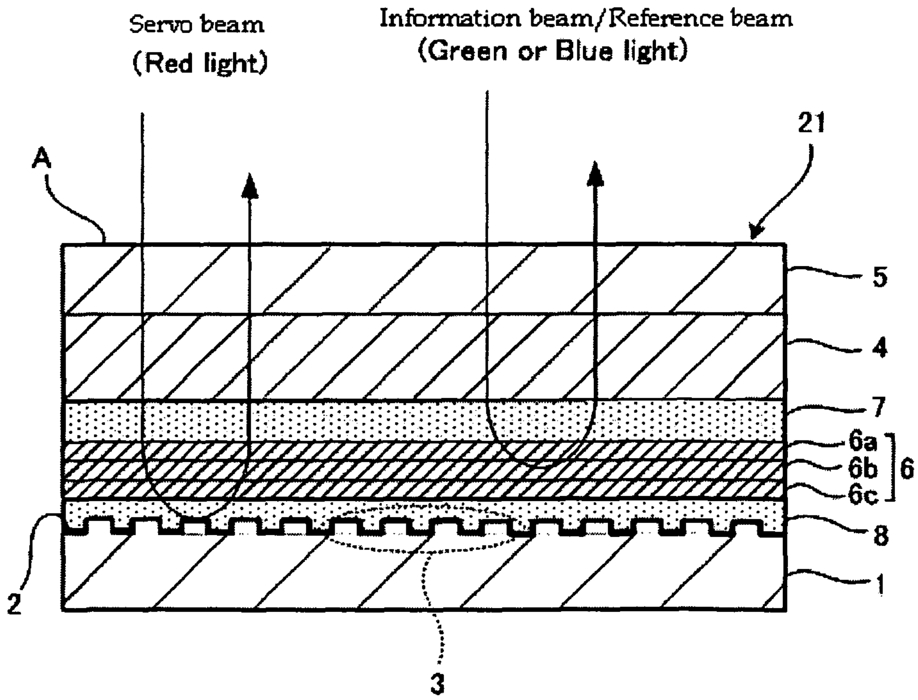
Servo beam
(Red light)
Information beam/Reference beam
(Green or Blue light)
21
A
5
4
7
6a
6b
6c
6
8
1
2
3

FIG. 3

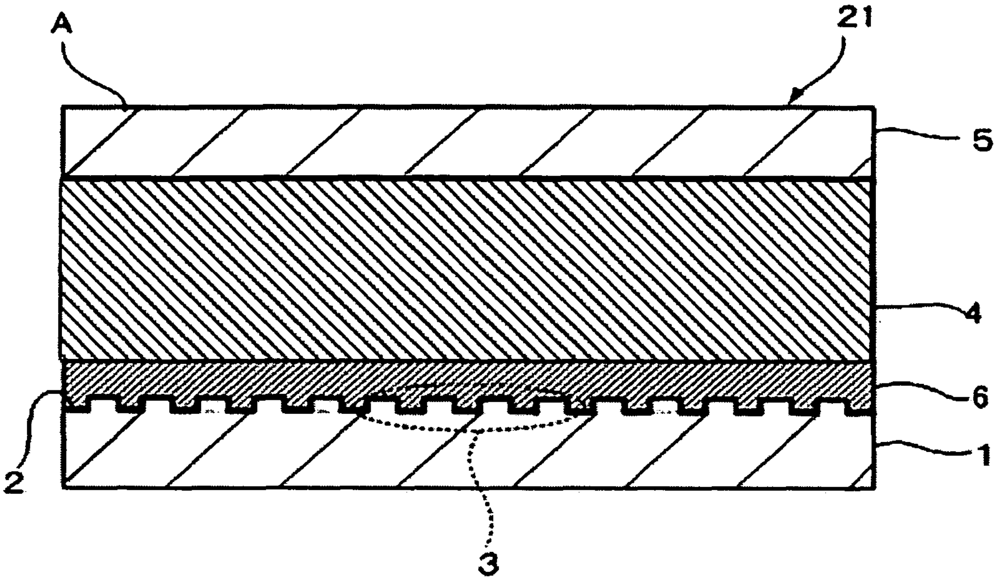


FIG. 4

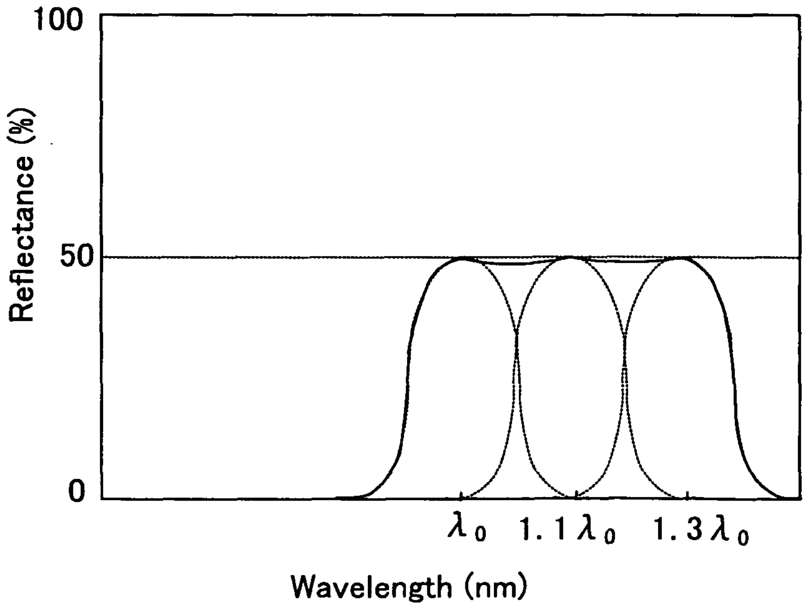

FIG. 5

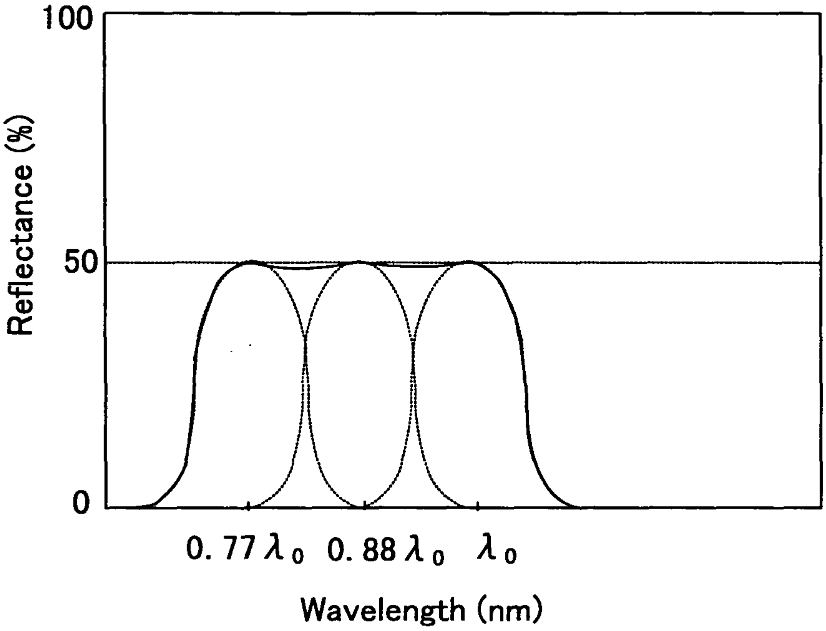
100
50
0
Reflectance (%)
0. 77 λ0
0. 88 λ0
λ0
Wavelength (nm)

FIG. 6

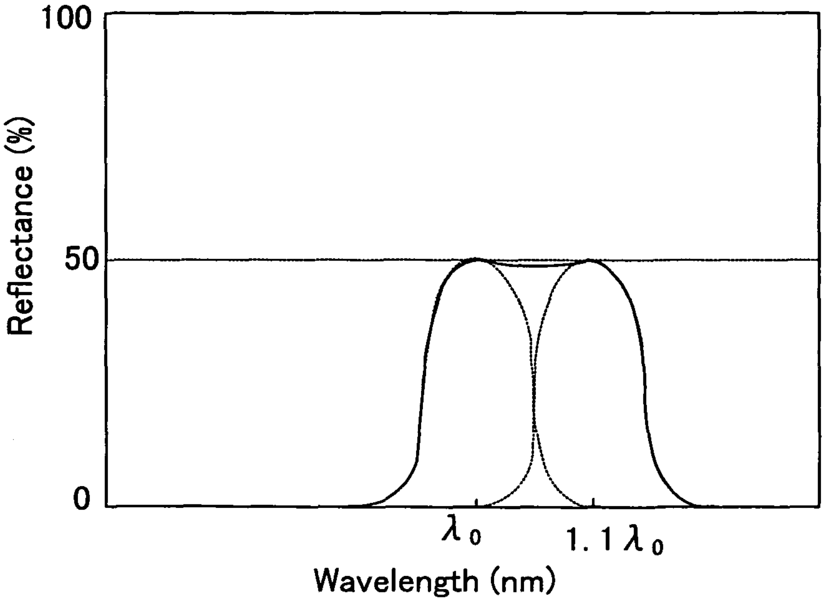
100
50
0
Reflectance (%)
λ0
1. 1 λ0
Wavelength (nm)

# FIG. 7

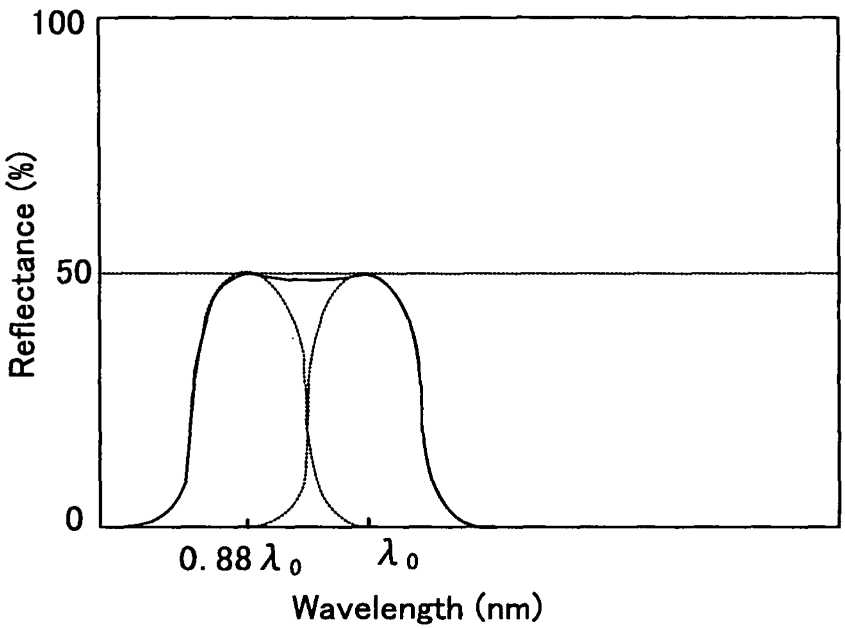

FIG. 8

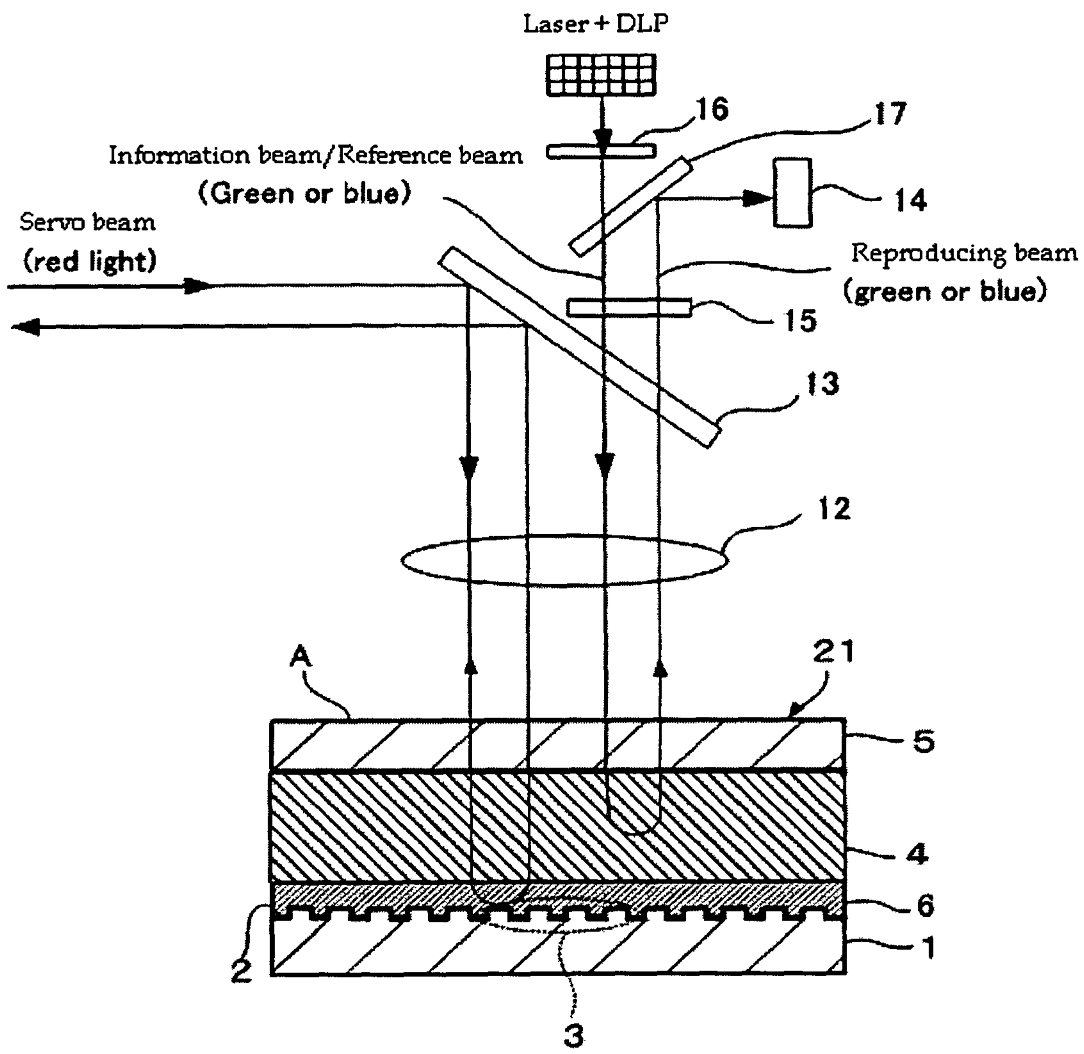
Laser + DLP
16
17
Information beam/Reference beam
(Green or blue)
14
Servo beam
(red light)
Reproducing beam
(green or blue)
15
13
12
A
21
5
4
6
1
2
3

FIG. 9

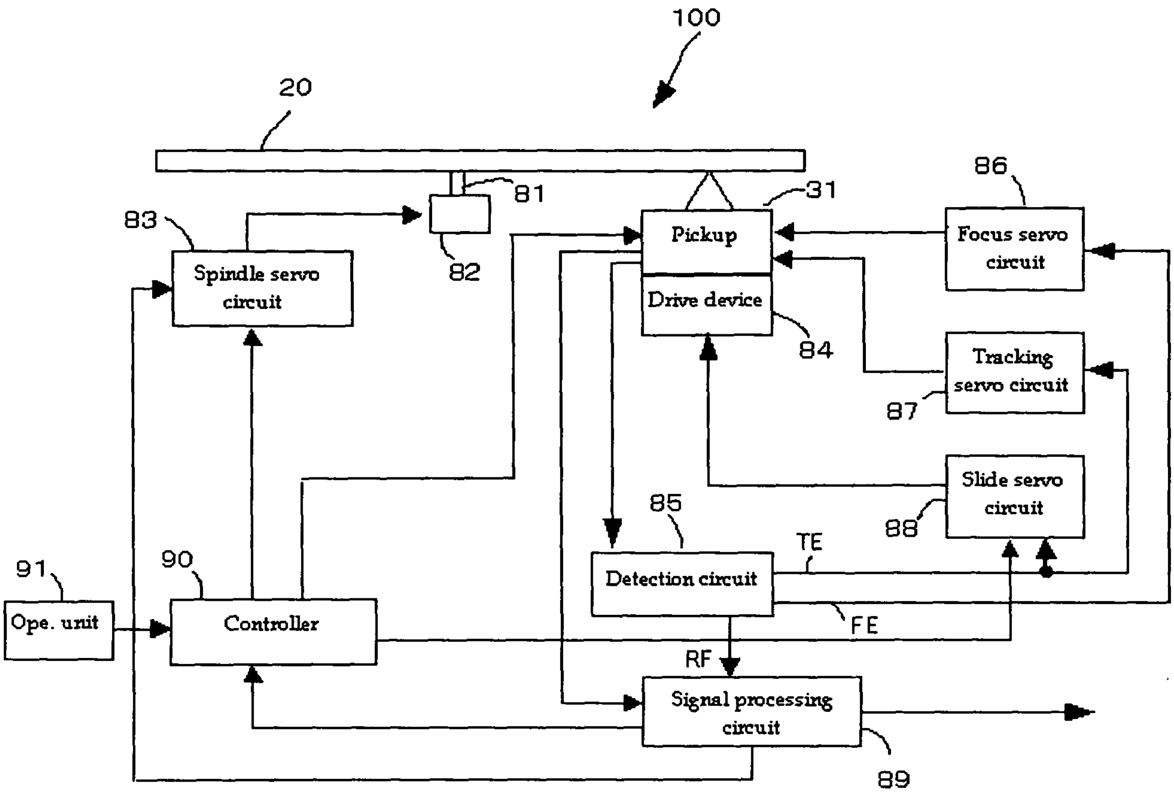
100
20
81
31
86
83
82
Pickup
Focus servo circuit
Spindle servo circuit
Drive device
84
Tracking servo circuit
87
Slide servo circuit
85
88
TE
91
90
Detection circuit
Ope. unit
Controller
FE
RF
Signal processing circuit
89

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2002123949 A
- JP 2004537620 A
- JP 2849021 B
- JP 8101499 A
- JP 3532679 B
- JP 2001125474 A
- JP 7199777 A
- JP 7199779 A
- JP 7104643 A
- US 3905815 A
- JP 46004605 B
- JP 48036281 A
- JP 55032070 A
- JP 60239736 A
- JP 61169835 A
- JP 61169837 A
- JP 62058241 A
- JP 62212401 A
- JP 63070243 A
- JP 63298339 A
- JP 8108621 A
- JP 59152396 A
- JP 61151197 A
- JP 63041484 A
- JP 2000249 A
- JP 2004705 A
- JP 5083588 A
- JP 1304453 A
- JP 1152109 A
- JP 6029285 B
- US 3479185 A
- US 4311783 A
- US 4622286 A
- JP 62143044 A
- JP 62150242 A
- JP 9188685 A
- JP 9188686 A
- JP 9188710 A
- JP 2000131837 A
- JP 2002107916 A
- JP 2764769 B
- JP 6157623 A
- JP 6175564 A
- JP 6175561 A
- JP 6175554 A
- JP 6175553 A
- JP 6348011 A
- JP 7128785 A
- JP 7140589 A
- JP 7306527 A
- JP 7292014 A
- JP 61166544 A
- JP 2002328465 A
- JP 2000066385 A
- JP 2000080068 A
- US 4069055 A
- JP 4365049 A
- US 4069056 A
- EP 104143 A
- US 339049 A
- US 410201 A
- JP 2150848 A
- JP 2296514 A
- EP 370693 A
- EP 390214 A
- EP 233567 A
- EP 297443 A
- EP 297442 A
- US 4933377 A
- US 161811 A
- US 4760013 A
- US 4734444 A
- US 2833827 A
- DE 2904626
- DE 3604580
- DE 3604581


### Non-patent literature cited in the description


- **WAKABAYASHI et al.** *Bull Chem. Soc. Japan,* 1969, vol. 42, 2924
- **M. P. HUTT.** *Journal of Heterocyclic Chemistry,* 1970, vol. 1 (3
- **KUNZ ; MARTIN.** *Rad Tech '98. Proceedings,* 19 April 1998
- *J. C. S. Perkin,* 1979, vol. II, 1653-1660
- *J. C. S. Perkin,* 1979, vol. II, 156-162
- *Journal of Photopolymer Science and Technology,* 1995, 202-232
- **S. I. SCHLESINGER.** *Photogr. Sci. Eng.,* 1974, vol. 18, 387
- **T. S. BAL et al.** *Polymer,* 1980, vol. 21, 423

- **J. V CRIVELLO et al.** *Macromolecules,* 1977, vol. 10 (6), 1307
- **J. V. CRIVELLO et al.** *J. Polymer Sci., Polymer Chem. Ed.,* 1979, vol. 17, 1047
- **C. S. WEN et al.** *Teh, Proc. Conf. Rad. Curing ASIA,* October 1988, 478